(19) 

**Europäisches Patentamt**
**European Patent Office**
**Office européen des brevets**

(11) **EP 2 782 278 A1**

(12) **EUROPEAN PATENT APPLICATION**
published in accordance with Art. 153(4) EPC

(43) Date of publication:
**24.09.2014 Bulletin 2014/39**

(21) Application number: **12850079.0**

(22) Date of filing: **16.11.2012**

(51) Int Cl.:
*H04J 99/00* (2009.01)       *H03M 13/27* (2006.01)
*H04B 7/04* (2006.01)       *H04J 11/00* (2006.01)

(86) International application number:
**PCT/JP2012/007374**

(87) International publication number:
**WO 2013/073195 (23.05.2013 Gazette 2013/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.11.2011   JP 2011253146
22.08.2012   JP 2012183571**

(71) Applicant: **Nippon Hoso Kyokai
Tokyo 150-8001 (JP)**

(72) Inventors:
• **ASAKURA, Shingo**
  **Tokyo 157-8510 (JP)**

• **MURAYAMA, Kenichi**
  **Tokyo 157-8510 (JP)**
• **TAGUCHI, Makoto**
  **Tokyo 157-8510 (JP)**
• **SHITOMI, Takuya**
  **Tokyo 157-8510 (JP)**
• **SHIBUYA, Kazuhiko**
  **Tokyo 157-8510 (JP)**

(74) Representative: **Epping - Hermann - Fischer
Patentanwaltsgesellschaft mbH
Schloßschmidstraße 5
80639 München (DE)**

(54) **TRANSMISSION DEVICE, RECEPTION DEVICE, TRANSMISSION METHOD, AND RECEPTION METHOD**

(57)       In a MIMO system performing MIMO transmission using a plurality of antennas, BER characteristics are improved. A transmission device (1) includes a mapping unit (13) that maps a transmission signal onto the IQ plane to generate carrier-modulated carrier symbols, a frequency/transmit antenna interleaving unit (frequency/polarized wave interleaving unit 15) that interleaves the carrier symbols in the frequency domain and between transmit antennas to generate interleaved data for each transmit antenna (17), and an output processing unit (16) that constructs an OFDM frame for the interleaved data for each transmit antenna (17) and transmits an OFDM signal via the transmit antennas (17).

*FIG. 1*

EP 2 782 278 A1

**Description**

CROSS-REFERENCE TO RELATED APPLICATION

This application claims priority to and the benefit of Japanese Patent Application No. 2011-253146 filed November 18, 2011 and Japanese Patent Application No. 2012-183571 filed August 22, 2012, the entire contents of which are incorporated herein by reference.

TECHNICAL FIELD

The present invention relates to a transmission device, reception device, transmission method, and reception method that perform Multiple Input Multiple Output (MIMO) transmission using a plurality of different antennas. In particular, the present invention relates, in a MIMO system, to a transmission device that performs interleaving between a plurality of antennas, a reception device that performs deinterleaving between a plurality of antennas, and methods thereof.

BACKGROUND ART

ISDB-T (Integrated Services Digital Broadcasting - Terrestrial), which is a digital terrestrial broadcasting system in Japan, implements high-vision broadcasting (or multiple standard definition broadcasting) for fixed receivers. There is demand for the next-generation digital terrestrial broadcasting system to provide service for an even larger amount of data to replace conventional high vision, such as 3D high vision broadcast or super high vision, which has 16 times the resolution of high vision.

In recent years, a Multiple Input Multiple Output (MIMO) system that uses a plurality of transmit/receive antennas has been proposed as a method for expanding the wireless data transmission capacity. In a transmission system using MIMO, Space Division Multiplexing (SDM) and Space Time Codes (STC) are used. As examples of implementing SDM, systems such as a polarized MIMO system that simultaneously uses both horizontal polarized waves and vertical polarized waves have been proposed.

In an actual channel for which broadcast service is assumed within a MIMO transmission using a plurality of transmit/receive antennas, the reception level may drop greatly for only one of the reception antennas due to differences in reflection characteristics or the like. With SDM transmission, since different streams are transmitted over the antennas, the Bit Error Rate (BER) characteristics of the entire system greatly degrade due to degradation of the BER characteristics resulting from a lower reception level for one antenna.

Conventionally, bit interleaving, time interleaving, and frequency interleaving, which reorder transmission data, are used with the ISDB-T system in order to increase efficiency of error correction (for example, see Non-patent Document 1). Also, a technique is known for expanding the interleaving in IEEE 802.11 into a MIMO system, dividing one stream up among a plurality of transmitters bit by bit, and performing bit interleaving transmitter by transmitter (for example, see Patent Document 1).

CITATION LIST

Patent Document

Patent Document 1: JP 2008-505558 A

Non-patent Document

Non-patent Document 1: "Transmission System for Digital Terrestrial Television Broadcasting", ARIB STD-B31, Association of Radio Industries and Businesses

SUMMARY OF INVENTION

(Technical Problem)

During SDM-MIMO transmission that transmits different streams using a plurality of antennas (for example, two antennas), if the reception level of antenna 1 is $R_1$, the reception level of antenna 2 is $R_2$, the bit error rate of antenna 1 is $BER_1$, and the bit error rate of antenna 2 is $BER_2$, then the reception level R and bit error rate BER of the overall MIMO transmission system using both antennas can be represented as averages using equations (1) and (2) below.

$$R = (R_1 + R_2)/2 \qquad (1)$$

$$BER = (BER_1 + BER_2)/2 \qquad (2)$$

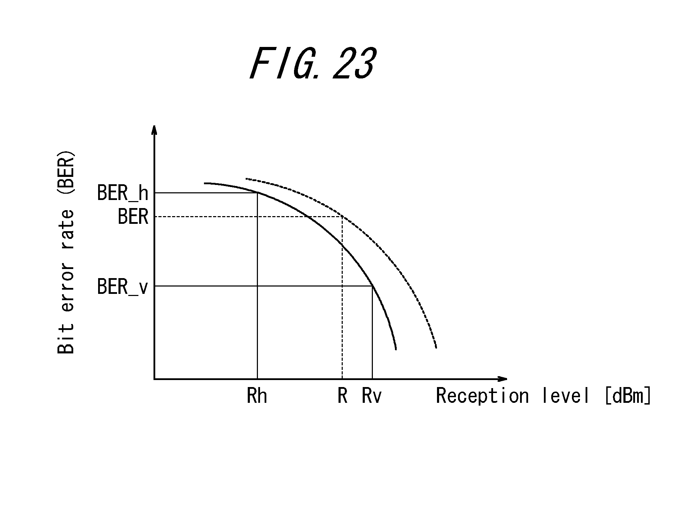

In SDM-MIMO transmission actually performed outdoors, a large difference in level occurs between antennas depending on location, due to factors such as different channel characteristics for the radio waves emitted from each antenna. When the reception level drops and the bit error rate degrades due only to the channel, the bit error rate of the entire system also degrades as per the above equation. FIG. 23 shows the BER characteristics for each antenna as a solid line and the BER characteristics after combination as a dashed line. This figure clearly shows how the BER characteristics after combination degrade. Accordingly, with SDM-MIMO transmission using a plurality of antennas, problems such as a lack of stable reception, a smaller coverage area, and the like occur due to degradation of BER characteristics caused by the difference in levels between antennas.

In order to solve these problems, it is an object of the present invention to provide a transmission device, a reception device, and methods therefor that can improve BER characteristics in a MIMO system performing SDM-MIMO transmission.

(Solution to Problem)

In order to solve the above problems, a transmission device according to the present invention is a transmission device for transmitting an OFDM signal using a plurality of transmit antennas, including: a mapping unit configured to map a transmission signal onto an IQ plane to generate a carrier-modulated carrier symbol; a frequency/transmit antenna interleaving unit (frequency/polarized wave interleaving unit in the below-described embodiment) configured to interleave the carrier symbol in a frequency domain and between transmit antennas to generate interleaved data for each transmit antenna; and an output processing unit configured to construct an OFDM frame for the interleaved data for each transmit antenna and transmit an OFDM signal via the transmit antennas.

Furthermore, in the transmission device according to the present invention, the frequency/transmit antenna interleaving unit may include: a data distribution unit configured to distribute the carrier symbol a predetermined number at a time to generate data for each transmit antenna; and a frequency interleaving unit configured to generate the interleaved data for each transmit antenna by interleaving the data for each transmit antenna in the frequency domain one OFDM carrier symbol at a time.

Furthermore, in the transmission device according to the present invention, the data distribution unit may generate the data for each transmit antenna by resolving the carrier symbol into I data along an I coordinate axis in an IQ plane and Q data along a Q coordinate axis in the IQ plane and distributing a predetermined amount at a time, with the I data and the Q data as a minimum unit.

Furthermore, in the transmission device according to the present invention, the frequency/transmit antenna interleaving unit may include: an inter-segment interleaving unit configured to generate data interleaved between segments by interleaving the carrier symbol in the frequency domain a number of OFDM carrier symbols at a time equal to a number of the transmit antennas; and a data distribution unit configured to generate the interleaved data for each transmit antenna by distributing the data interleaved between segments a predetermined amount at a time.

Furthermore, in the transmission device according to the present invention, the inter-segment interleaving unit may generate the data interleaved between segments by resolving the carrier symbol into I data along an I coordinate axis in an IQ plane and Q data along a Q coordinate axis in the IQ plane and interleaving the I data and the Q data in the frequency domain a number of OFDM carrier symbols at a time equal to the number of the transmit antennas, with the I data and the Q data as a minimum unit.

Furthermore, in the transmission device according to the present invention, the frequency/transmit antenna interleaving unit may include: a random number table storage unit configured to store a random number table for determining allocation of a number of OFDM carrier symbols, in the carrier-modulated data, equal to a number of the transmit antennas; a data randomization unit configured to reorder the carrier symbol a number of OFDM carrier symbols at a time equal to the number of the transmit antennas by referring to the random number table; and a data distribution unit configured to generate the interleaved data for each transmit antenna by distributing a predetermined number at a time of carrier symbols reordered by the data randomization unit.

Furthermore, in the transmission device according to the present invention, the data randomization unit may resolve the carrier symbol into I data along an I coordinate axis in an IQ plane and Q data along a Q coordinate axis in the IQ plane and reorders the I data and Q data a number of OFDM carrier symbols at a time equal to the number of the transmit antennas, with the I data and the Q data as a minimum unit, by referring to the random number table.

In order to solve the above problems, a transmission device according to the present invention is a transmission device for transmitting an OFDM signal over a plurality of channels using a plurality of transmit antennas per channel, including: a mapping unit configured to map transmission signals for the plurality of channels onto an IQ plane to generate carrier-modulated carrier symbols for the plurality of channels; a frequency/transmit antenna interleaving unit (frequency/polarized wave/channel interleaving unit in the below-described embodiment) configured to interleave the carrier symbols for the plurality of channels in a frequency domain and between transmit antennas to generate interleaved data for each transmit antenna; and an output processing unit configured to construct an OFDM frame for the interleaved data for each transmit antenna and transmit an OFDM signal via the transmit antennas.

In the transmission device according to the present invention, the output processing unit may transmit the OFDM signal via a horizontal polarized wave antenna and a vertical polarized wave antenna, or via a right-handed circularly polarized wave antenna and a left-handed circularly polarized wave antenna.

In order to solve the above problems, a reception device according to the present invention is a reception device for receiving an OFDM signal using a plurality of receive antennas, including: a MIMO detection unit configured to generate an isolation signal by using a channel response to perform waveform equalization and isolation on an OFDM signal received by the plurality of receive antennas; a first deinterleaving unit (first frequency/polarized wave deinterleaving unit 25 or first frequency/polarized wave/channel deinterleaving unit 32 in the below-described embodiments) configured to deinterleave the isolation signal in a frequency domain and between receive antennas; a noise variance calculation unit configured to calculate a noise variance of the OFDM signal; a second deinterleaving unit (second frequency/polarized wave deinterleaving unit 27 or second frequency/polarized wave/channel deinterleaving unit 33 in the below-described embodiments) configured to deinterleave the noise variance in the frequency domain and between receive antennas; a likelihood ratio calculation unit configured to calculate a likelihood ratio using the isolation signal deinterleaved by the first frequency/receive antenna deinterleaving unit and the noise variance deinterleaved by the second frequency/receive antenna deinterleaving unit; and an error correcting code decoding unit configured to decode an error correcting code using the likelihood ratio.

In order to solve the above problems, a transmission method according to the present invention is a transmission method for generating an OFDM signal to be transmitted from a plurality of transmit antennas, including the steps of: mapping a transmission signal onto an IQ plane to generate a carrier-modulated carrier symbol; interleaving the carrier symbol in a frequency domain and between transmit antennas to generate interleaved data for each transmit antenna; and constructing an OFDM frame for the interleaved data for each transmit antenna and generating an OFDM signal to be transmitted from the transmit antennas.

In order to solve the above problems, a transmission method according to the present invention is a transmission method for generating an OFDM signal to be transmitted from a plurality of transmit antennas per channel, including the steps of: mapping transmission signals for the plurality of channels onto an IQ plane to generate carrier-modulated carrier symbols for the plurality of channels; interleaving the carrier symbols for the plurality of channels in a frequency domain and between transmit antennas to generate interleaved data for each transmit antenna; and constructing an OFDM frame for the interleaved data for each transmit antenna and generating an OFDM signal to be transmitted from the transmit antennas.

In order to solve the above problems, a reception method according to the present invention is a reception method for processing an OFDM signal received from a plurality of receive antennas, comprising the steps of: generating an isolation signal by using a channel response to perform waveform equalization and isolation on an OFDM signal; performing first deinterleaving by deinterleaving the isolation signal in a frequency domain and between receive antennas; calculating a noise variance of the OFDM signal; performing second deinterleaving by deinterleaving the noise variance in the frequency domain and between receive antennas; calculating a likelihood ratio using the isolation signal deinterleaved in the first deinterleaving step and the noise variance deinterleaved in the second deinterleaving step; and decoding an error correcting code using the likelihood ratio.


(Advantageous Effect of Invention)


According to the present invention, in a MIMO system performing SDM-MIMO transmission, BER characteristics can be improved by interleaving between polarized waves. Hence, the coverage area can be expanded and reception can be stabilized.


BRIEF DESCRIPTION OF DRAWINGS


The present invention will be further described below with reference to the accompanying drawings, wherein:

FIG. 1 is a block diagram illustrating the structure of a transmission device according to Embodiment 1 of the present invention;

FIG. 2 is a block diagram illustrating the structure of a reception device according to Embodiment 1 of the present invention;

FIG. 3 illustrates processing by a noise variance calculation unit in the reception device according to Embodiment 1 of the present invention;

FIG. 4 is a block diagram illustrating the structure of a frequency/polarized wave interleaving unit in the first example for the transmission device according to Embodiment 1 of the present invention;

FIG. 5 illustrates processing by the inter-segment interleaving unit in the first example of frequency/polarized wave interleaving for the transmission device according to Embodiment 1 of the present invention;

FIG. 6 illustrates processing by a data rotation unit in the first example of frequency/polarized wave interleaving for the transmission device according to Embodiment 1 of the present invention;

FIG. 7 illustrates processing by a data randomization unit in the first example of frequency/polarized wave interleaving for the transmission device according to Embodiment 1 of the present invention;

FIG. 8 illustrates the structure of a transmission device that performs data distribution on bit data before mapping for the sake of comparison with the transmission device according to Embodiment 1 of the present invention;

FIG. 9 shows simulation results for the bit error rate of the transmission device 1 in FIG. 1 and the transmission device 1' in FIG. 8;

FIG. 10 illustrates processing by the inter-segment interleaving unit in the second example of frequency/polarized wave interleaving for the transmission device according to Embodiment 1 of the present invention;

FIG. 11 is a block diagram illustrating the structure of a frequency/polarized wave interleaving unit in the third example for the transmission device according to Embodiment 1 of the present invention;

FIG. 12 illustrates processing by the inter-segment interleaving unit in the third example of frequency/polarized wave interleaving for the transmission device according to Embodiment 1 of the present invention;

FIG. 13 illustrates processing by the inter-segment interleaving unit in the fourth example of frequency/polarized wave interleaving for the transmission device according to Embodiment 1 of the present invention;

FIG. 14 is a block diagram illustrating the structure of the frequency/polarized wave interleaving unit in the fifth example for the transmission device according to Embodiment 1 of the present invention;

FIG. 15 shows simulation results for the bit error rate of the transmission device according to Embodiment 1 of the present invention;

FIG. 16 is a block diagram illustrating the structure of a transmission device according to Embodiment 2 of the present invention;

FIG. 17 is a block diagram illustrating the structure of a reception device according to Embodiment 2 of the present invention;

FIG. 18 is a block diagram illustrating the structure of the frequency/polarized wave/channel interleaving unit in the first example for the transmission device according to Embodiment 2 of the present invention;

FIG. 19 is a block diagram illustrating the structure of the frequency/polarized wave/channel interleaving unit in the third example for the transmission device according to Embodiment 2 of the present invention;

FIG. 20 illustrates processing by the inter-segment interleaving unit in the third example of frequency/polarized wave/channel interleaving for the transmission device according to Embodiment 2 of the present invention;

FIG. 21 illustrates processing by the inter-segment interleaving unit in the fourth example of frequency/polarized wave/channel interleaving for the transmission device according to Embodiment 2 of the present invention;

FIG. 22 is a block diagram illustrating the structure of the frequency/polarized wave/channel interleaving unit in the fifth example for the transmission device according to Embodiment 2 of the present invention;

FIG. 23 illustrates degradation of bit error rate characteristics due to a difference in reception level;

FIG. 24 is a flowchart showing the transmission method according to the present invention; and

FIG. 25 is a flowchart showing the reception method according to the present invention.

## DESCRIPTION OF EMBODIMENTS

In general with error correcting codes, correction is difficult when errors occur consecutively in data. Therefore, by the transmission device interleaving the data and the reception device deinterleaving the received data to restore the original data, erroneous data is dispersed throughout, thereby improving the error correcting ability. ISDB-T, the digital broadcast system in Japan, has been designed to achieve optimal performance under a variety of conditions by performing bit interleaving, frequency interleaving, and time interleaving. By performing interleaving between transmit antennas in addition to these interleaving processes, the present invention allows for improved transmission characteristics for the entire MIMO system by dispersing, between transmit antennas, the erroneous data resulting from a difference in level between transmit antennas. As an example of MIMO using a plurality of antennas, polarized MIMO that uses the orthogonality of horizontal polarized waves and vertical polarized waves is described. The transmission device and reception device according to the present invention, however, are not limited to polarized MIMO transmission and are also effective for general SDM-MIMO transmission.

<Embodiment 1>

[Transmission device]

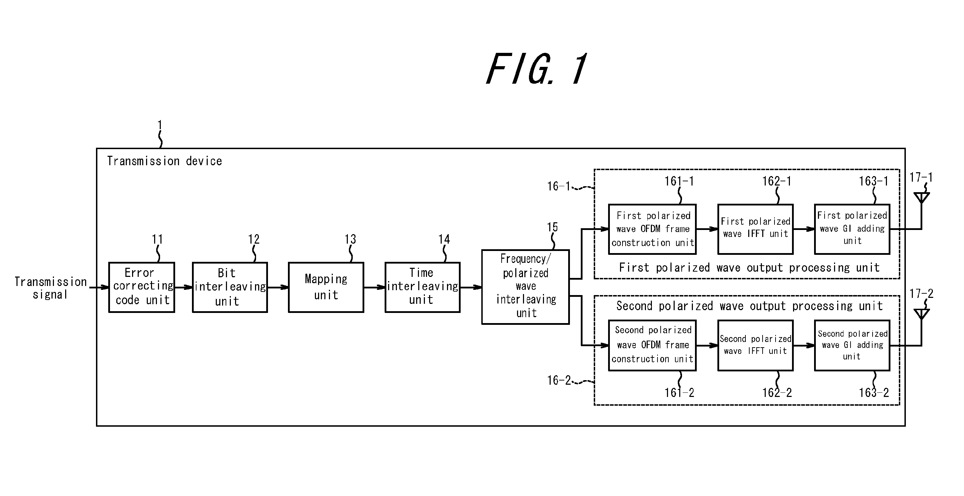

First, the transmission device according to Embodiment 1 of the present invention is described. The transmission device transmits an OFDM signal using different polarized waves from a plurality of transmit antennas. FIG. 1 is a block diagram illustrating the structure of the transmission device according to Embodiment 1 of the present invention. As illustrated in FIG. 1, a transmission device 1 includes an error correcting code unit 11, a bit interleaving unit 12, a mapping unit 13, a time interleaving unit 14, a frequency/polarized wave interleaving unit 15, a first polarized wave output processing unit 16-1, a second polarized wave output processing unit 16-2, a first polarized wave transmit antenna 17-1, and a second polarized wave transmit antenna 17-2. The first polarized wave output processing unit 16-1 includes a first polarized wave OFDM frame construction unit 161-1, a first polarized wave IFFT unit 162-1, and a first polarized wave GI adding unit 163-1. The second polarized wave output processing unit 16-2 includes a second polarized wave OFDM frame construction unit 161-2, a second polarized wave IFFT unit 162-2, and a second polarized wave GI adding unit 163-2. The bit interleaving unit 12 adheres to the Digital Video Broadcasting-Cable 2 (DVB-C2) system for reasons described below. Otherwise, the processing by each block except for the frequency/polarized wave interleaving unit 15 adheres to the ISDB-T system.

The first polarized wave output processing unit 16-1 processes transmission data for the first polarized wave, and the second polarized wave output processing unit 16-2 processes transmission data for the second polarized wave. The first polarized wave and the second polarized wave are two types of separable polarized waves, such as a horizontal polarized wave and a vertical polarized wave, a right-handed circularly polarized wave and a left-handed circularly polarized wave, or the like. In the following explanation, when it is not necessary to distinguish between the first polarized wave and the second polarized wave, then the first polarized wave output processing unit 16-1 and the second polarized wave output processing unit 16-2 are referred to as output processing units 16, the first polarized wave OFDM frame construction unit 161-1 and the second polarized wave OFDM frame construction unit 161-2 are referred to as OFDM frame construction units 161, the first polarized wave IFFT unit 162-1 and the second polarized wave IFFT unit 162-2 are referred to as IFFT units 162, the first polarized wave GI adding unit 163-1 and the second polarized wave GI adding unit 163-2 are referred to as GI adding units 163, and the first polarized wave transmit antenna 17-1 and second polarized wave transmit antenna 17-2 are referred to as transmit antennas 17.

So that transmission errors are correctable at the receiving side, the error correcting code unit 11 codes the input transmission signal with an error correcting code. For error correction, for example a BCH code is used as the outer code, and a Low Density Parity Check (LDPC) is used as the inner code.

In order to increase the performance of the error correcting code, the bit interleaving unit 12 interleaves, bit by bit, the transmission signal output by the error correcting code unit 11. When using an LDPC code as the outer code for error correction, it is known that a method such as that used with DVB-C2 is effective as the bit interleaving method. ETSI EN 302 769 V1.2.1 (p. 32) or http://www.dvb.org/technology/dvbc2/ may be referred to regarding the bit interleaving method of DVB-C2.

The mapping unit 13 maps m bits/symbol onto the IQ plane to generate carrier symbols that are carrier modulated in accordance with a modulation scheme.

The time interleaving unit 14 reorders, in the time domain, the carrier symbols input from the mapping unit 13.

The frequency/polarized wave interleaving unit 15 reorders, in the frequency domain and between polarized waves (between transmit antennas), the carrier symbols that are input from the time interleaving unit 14 and have been interleaved in the time domain, thereby generating interleaved data for each transmit antenna 17. Specific examples of interleaving are described below.

The output processing units 16 construct OFDM frames for the interleaved data input from the frequency/polarized wave interleaving unit 15 and transmit OFDM signals via the transmit antennas 17. The transmit antennas 17 are a horizontal polarized wave antenna and a vertical polarized wave antenna, or a right-handed circularly polarized wave antenna and a left-handed circularly polarized wave antenna.

The OFDM frame construction units 161 insert a pilot signal (SP signal), a TMCC signal indicating control information, and an AC signal indicating additional information into the signal input from the frequency/polarized wave interleaving unit 15, and with all of the carriers as one OFDM symbol, construct an OFDM frame with a block of a predetermined number of OFDM symbols.

The IFFT units 162 perform an Inverse Fast Fourier Transform (IFFT) on the OFDM symbols input from the OFDM frame construction units 161 to generate valid symbol signals in the time domain.

The GI adding units 163 insert a guard interval, which is a copy of the latter half of a valid symbol signal, at the beginning of each valid symbol signal input from the IFFT units 162 and transmit analog signals, on which orthogonal modulation and D/A conversion have been performed, to the outside via the transmit antennas 17.

[Reception device]

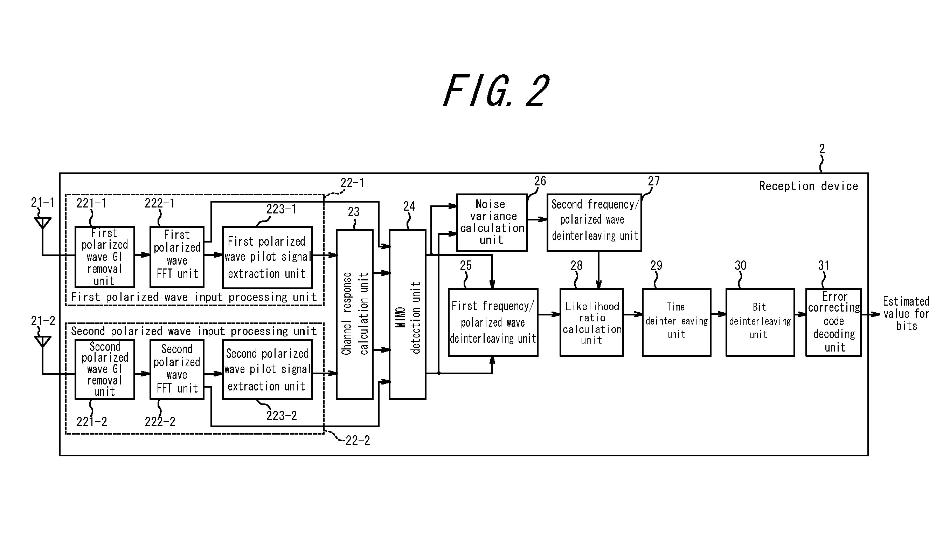

Next, the reception device according to Embodiment 1 of the present invention is described. The reception device receives the OFDM signals transmitted by the above-described transmission device 1 via a plurality of receive antennas. FIG. 2 is a block diagram illustrating the structure of the reception device according to Embodiment 1 of the present invention. As illustrated in FIG. 2, the reception device 2 includes a first polarized wave receive antenna 21-1, a second polarized wave receive antenna 21-2, a first polarized wave input processing unit 22-1, a second polarized wave input processing unit 22-2, a channel response calculation unit 23, a MIMO detection unit 24, a first frequency/polarized wave deinterleaving unit 25, a noise variance calculation unit 26, a second frequency/polarized wave deinterleaving unit 27, a likelihood ratio calculation unit 28, a time deinterleaving unit 29, a bit deinterleaving unit 30, and an error correcting code decoding unit 31. The first polarized wave input processing unit 22-1 includes a first polarized wave GI removal unit 221-1, a first polarized wave FFT unit 222-1, and a first polarized wave pilot signal extraction unit 223-1. The second polarized wave input processing unit 22-2 includes a second polarized wave GI removal unit 221-2, a second polarized wave FFT unit 222-2, and a second polarized wave pilot signal extraction unit 223-2.

The first polarized wave and second polarized wave are the same as the first polarized wave and second polarized wave of the transmission device 1. In the following explanation, when it is not necessary to distinguish between the first polarized wave and the second polarized wave, then the first polarized wave receive antenna 21-1 and the second polarized wave receive antenna 21-2 are referred to as receive antennas 21, the first polarized wave input processing unit 22-1 and the second polarized wave input processing unit 22-2 are referred to as input processing units 22, the first polarized wave GI removal unit 221-1 and the second polarized wave GI removal unit 221-2 are referred to as GI removal units 221, the first polarized wave FFT unit 222-1 and the second polarized wave FFT unit 222-2 are referred to as FFT units 222, and the first polarized wave pilot signal extraction unit 223-1 and the second polarized wave pilot signal extraction unit 223-2 are referred to as pilot signal extraction units 223.

The input processing units 22 receive the OFDM signals transmitted by the transmission device 1 via the receive antennas 21. The GI removal units 221 perform orthogonal demodulation on the received OFDM signals to generate baseband signals and then generate analog signals by A/D conversion. The GI removal units 221 then remove the guard intervals to extract the valid symbol signals.

The FFT units 222 perform a Fast Fourier Transform (FFT) on the valid symbol signals input from the GI removal units 221 to generate complex baseband signals.

The pilot signal extraction units 223 extract pilot signals (SP signals) from the complex baseband signals input from the FFT units 222.

The channel response calculation unit 23 calculates the channel response using the pilot signals input from the pilot signal extraction units 223.

By applying a known method, such as Zero Forcing (ZF), Minimum Mean Squared Error (MMSE), Bell Laboratories Layered Space-Time (BLAST), Maximum Likelihood Detection (MLD), or the like, to the baseband signal input from the FFT unit 222, the MIMO detection unit 24 uses the channel response input from the channel response calculation unit 23 to generate an isolation signal that is a waveform equalization and isolation of the polarized wave signals transmitted by the transmission device 1.

The first frequency/polarized wave deinterleaving unit 25 performs deinterleaving in the frequency domain and between polarized waves (between receive antennas) on the isolation signal input from the MIMO detection unit 24 (the reverse of the processing by the frequency/polarized wave interleaving unit 15 of the transmission device 1).

The reception device 2 needs to calculate the noise variance in order to calculate the likelihood ratio necessary for LDPC decoding. The noise variance of the entire band may be calculated from the data carrier (isolation signal) deinterleaved by the first frequency/polarized wave deinterleaving unit 25, yet in order to calculate a more precise noise variance, it is necessary to weight the noise variance for each carrier, as described below. Accordingly, in the reception device 2 illustrated in FIG. 2, the noise variance calculation unit 26 is not placed between the first frequency/polarized wave deinterleaving unit 25 and the likelihood ratio calculation unit 28, but rather before the first frequency/polarized wave deinterleaving unit 25.

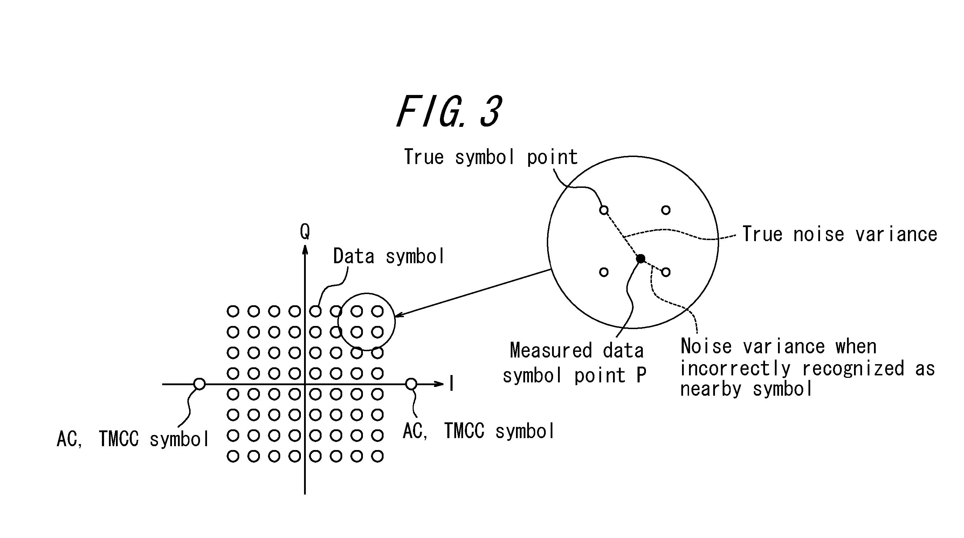

The noise variance calculation unit 26 calculates the noise variance from the polarized wave signals input from the MIMO detection unit 24. The noise variance $\sigma^2$ represents the misalignment between the symbol point in IQ coordinates at which the carrier symbol should be and the symbol point P of the actually measured carrier symbol. The noise variance $\sigma^2$ is obtained by calculating the modulation error ratio and taking the inverse. This is because of multiplication by a normalization factor, which takes the average power in the band to be 1. FIG. 3 illustrates processing by the noise variance calculation unit 26. There are a variety of methods for calculating the noise variance, yet as illustrated in FIG. 3, when calculating the noise variance for a symbol point P, the probably of incorrect recognition is lower when calculating from the AC symbol and/or the TMCC symbol than when calculating from a data symbol to which multilevel modulation has been applied (64 QAM in the example in FIG. 3). Therefore, before performing frequency/polarized wave deinterleaving on the data symbol, the noise variance calculation unit 26 preferably uses the AC symbol and/or the TMCC symbol to calculate the average noise variance for the entire OFDM carrier symbol.

When a multipath exists in the channel, the noise variance fluctuates since the power differs between OFDM carriers. The noise variance $\sigma^2$ is necessary for calculating the likelihood ratio for each bit constituting each carrier symbol, and calculating the noise variance for each carrier as accurately as possible determines the performance of the LDPC decoding. Therefore, using a weighting matrix determined from the channel response, the noise variance is established by weighting, for each carrier, the average noise variance of the entire band. It is known that the weighting matrix for each carrier can be represented as $(H^H H)^{-1}$ for the channel response matrix H. The weight element for each carrier can be represented by this diagonal element. Weighting is performed via normalizing by all of the carriers and multiplying by the average noise variance of the entire band. A description of the decoding method to multiply the information on the signal vs. power for each carrier (C/N) by the likelihood calculation can be found, for example, in Nakahara, "A Study on soft decision decoding of 64QAM modulated OFDM signals under multi path distortion", ITE Technical Report vol. 22, no. 34, pp. 1-6, Jun. 1998. Details on weighting matrix calculation and the like can be found for example in Ohgane and Ogawa, "Easy to understand MIMO system technology" (English translation of original Japanese title), Ohmsha, p. 101.

The second frequency/polarized wave deinterleaving unit 27 performs deinterleaving in the frequency domain and between polarized waves (between receive antennas) on the noise variance for the polarized wave signals input from the noise variance calculation unit 26 (the reverse of the processing by the frequency/polarized wave interleaving unit 15 of the transmission device 1).

The likelihood ratio calculation unit 28 calculates a likelihood ratio $\lambda$ using the deinterleaved data input from the first frequency/polarized wave deinterleaving unit 25 and the noise variance $\sigma^2$ input from the second frequency/polarized wave deinterleaving unit 27 for the data. The likelihood ratio $\lambda$ is calculated for each bit of the error correcting code and represents information on the stochastic reliability of the received signal. The Log-Likelihood Ratio (LLR) is generally used as the likelihood ratio. For example, the LLR $\lambda$ for BPSK modulation is represented by equation (3) below, where y is the measured value, since the probability P (likelihood function) for each of two values (x = 0, 1) is a Gaussian distribution. Details can be found for example in Wadayama, "Low Density Parity Check Codes and the Decoding Thereof" (English translation of original Japanese title), Triceps.

$$\lambda = \ln\frac{P(y\mid x=0)}{P(y\mid x=1)} = \ln\frac{\dfrac{1}{\sqrt{2\pi\sigma^2}}\exp(-\dfrac{(y-1)^2}{2\sigma^2})}{\dfrac{1}{\sqrt{2\pi\sigma^2}}\exp(-\dfrac{(y+1)^2}{2\sigma^2})}$$

$$(3)$$

The time deinterleaving unit 29 deinterleaves, in the time domain, the likelihood ratio $\lambda$ input from the likelihood ratio calculation unit 28 (the reverse of the processing by the time interleaving unit 14 of the transmission device 1). The time deinterleaving unit 29 then outputs the deinterleaved likelihood ratio $\lambda$ to the bit deinterleaving unit 30.

The bit deinterleaving unit 30 deinterleaves, in the bit domain, the likelihood ratio $\lambda$ generated by the time deinterleaving unit 29 (the reverse of the processing by the bit interleaving unit 12 of the transmission device 1). The bit deinterleaving unit 30 then outputs the deinterleaved likelihood ratio $\lambda$ to the error correcting code decoding unit 31.

The error correcting code decoding unit 31 decodes the error correcting code using the likelihood ratio $\lambda$ input from the bit deinterleaving unit 30 and outputs estimated values for the bits transmitted by the transmission device 1.

[Frequency/polarized wave interleaving unit]

Next, the frequency/polarized wave interleaving unit 15 is described. Note that the first frequency/polarized wave deinterleaving unit 25 and the second frequency/polarized wave deinterleaving unit 27 reorder data in the reverse direction from the frequency/polarized wave interleaving unit 15 to restore the data to the original order. Since the block diagram of the frequency/polarized wave interleaving unit 15 and the direction of signal line arrows are simply reversed, a description is omitted.

[First example of interleaving]

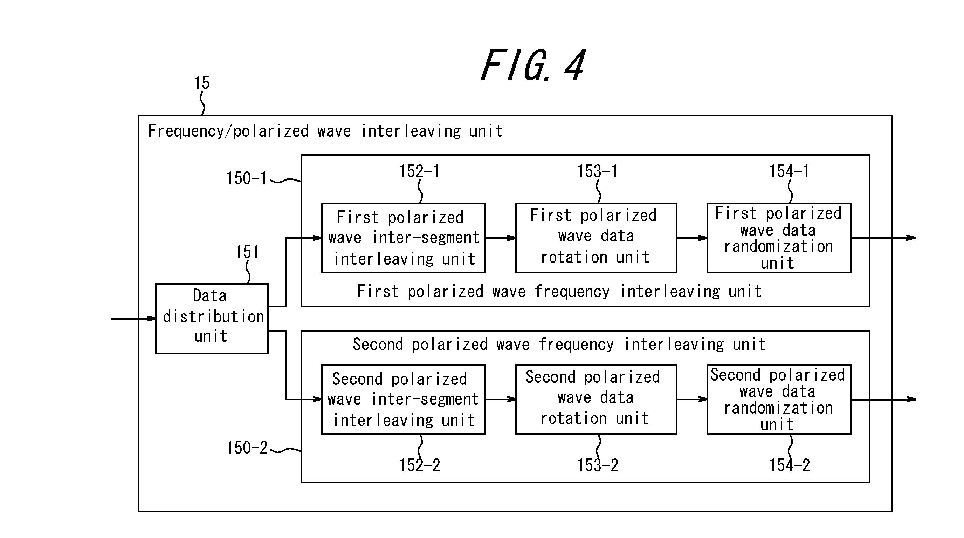

In the first example of interleaving, the frequency/polarized wave interleaving unit 15 performs frequency interleaving for each polarized wave after classifying a predetermined number of carrier symbols at a time into first polarized wave transmission data and second polarized wave transmission data. FIG. 4 is a block diagram showing the structure of the first example of the frequency/polarized wave interleaving unit 15. In the first example, the frequency/polarized wave interleaving unit 15 includes a data distribution unit 151, a first polarized wave frequency interleaving unit 150-1, and a second polarized wave frequency interleaving unit 150-2. The first polarized wave frequency interleaving unit 150-1 includes a first polarized wave inter-segment interleaving unit 152-1, a first polarized wave data rotation unit 153-1, and a first polarized wave data randomization unit 154-1. The second polarized wave frequency interleaving unit 150-2 includes a second polarized wave inter-segment interleaving unit 152-2, a second polarized wave data rotation unit 153-2, and a second polarized wave data randomization unit 154-2. In the following explanation, when it is not necessary to distinguish between the first polarized wave and the second polarized wave, then the first polarized wave frequency interleaving unit 150-1 and the second polarized wave frequency interleaving unit 150-2 are referred to as frequency interleaving units 150, the first polarized wave inter-segment interleaving unit 152-1 and the second polarized wave inter-segment interleaving unit 152-2 are referred to as inter-segment interleaving units 152, the first polarized wave data rotation unit 153-1 and the second polarized wave data rotation unit 153-2 are referred to as data rotation units 153, and the first polarized wave data randomization unit 154-1 and the second polarized wave data randomization unit 154-2 are referred to as data randomization units 154.

The data distribution unit 151 distributes a predetermined number at a time of carrier symbols input from the time interleaving unit 14 to the first polarized wave frequency interleaving unit 150-1 and the second polarized wave frequency interleaving unit 150-2. In order to increase the interleaving effect, the data distribution unit 151 preferably distributes carrier symbols one at a time, i.e. outputs odd-numbered carrier symbols to the first polarized wave frequency interleaving unit 150-1 and even-numbered carrier symbols to the second polarized wave frequency interleaving unit 150-2.

The frequency interleaving units 150 perform interleaving with, for example, the method used in ISDB-T, interleaving the data of each polarized wave distributed by the data distribution unit 151 (the data for each transmit antenna) in the frequency domain one OFDM symbol at the time.

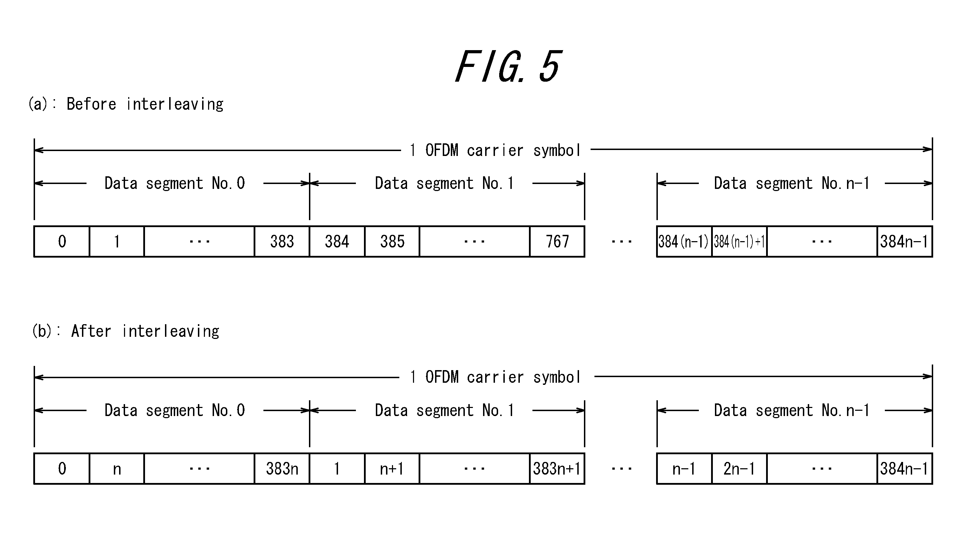

FIG. 5 illustrates processing by the inter-segment interleaving units 152, with FIG. 5(a) representing the symbol allocation before interleaving and FIG. 5(b) representing the symbol allocation after interleaving. The inter-segment interleaving units 152 interleave the carrier symbols input from the data distribution unit 151 between segments in the frequency domain one OFDM carrier symbol at a time. In the example shown in FIG. 5, the number of segments in one OFDM carrier symbol is n (where n = 13 with the ISDB-T system), and the number of carrier symbols per segment is 384. Note that this reordering is only a non-limiting example.

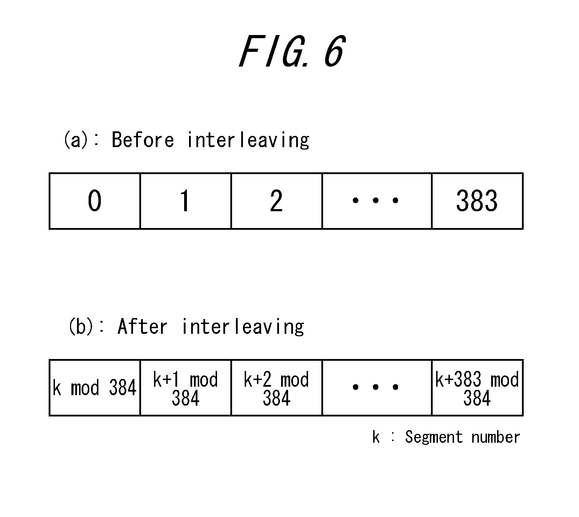

FIG. 6 illustrates processing by the data rotation units 153, with FIG. 6(a) representing the symbol allocation before interleaving and FIG. 6(b) representing the symbol allocation after interleaving. The data rotation units 153 interleave the carrier symbols input from the inter-segment interleaving units 152 one segment at a time by data rotation. In FIG. 6, as in FIG. 5, the number of carrier symbols per segment is 384. The data rotation units 153 reorder the data in the $i^{th}$ position of the $k^{th}$ segment to the $i'^{th}$ position of the $k^{th}$ segment by data rotation. In the example shown in FIG. 6, $i' = (i + k) \bmod 384$. Note that this reordering is only a non-limiting example.

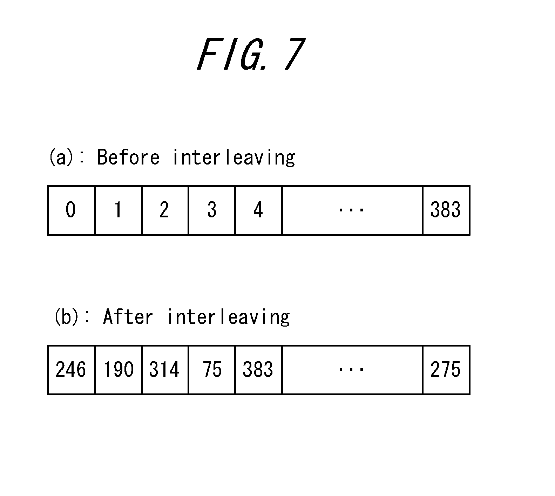

FIG. 7 illustrates processing by the data randomization units 154, with FIG. 7(a) representing the symbol allocation before interleaving and FIG. 7(b) representing the symbol allocation after interleaving. The data randomization units 154 store, in advance, a random number table for the number of carrier symbols within a segment (the same random number table at the transmitting side and the receiving side) and randomize the data input from the data rotation units 153 within a segment by referring to the random number table, thereby eliminating periodicity. In FIG. 7, as in FIGS. 5 and 6, the number of carrier symbols per segment is 384. Note that the random numbers are only a non-limiting example.

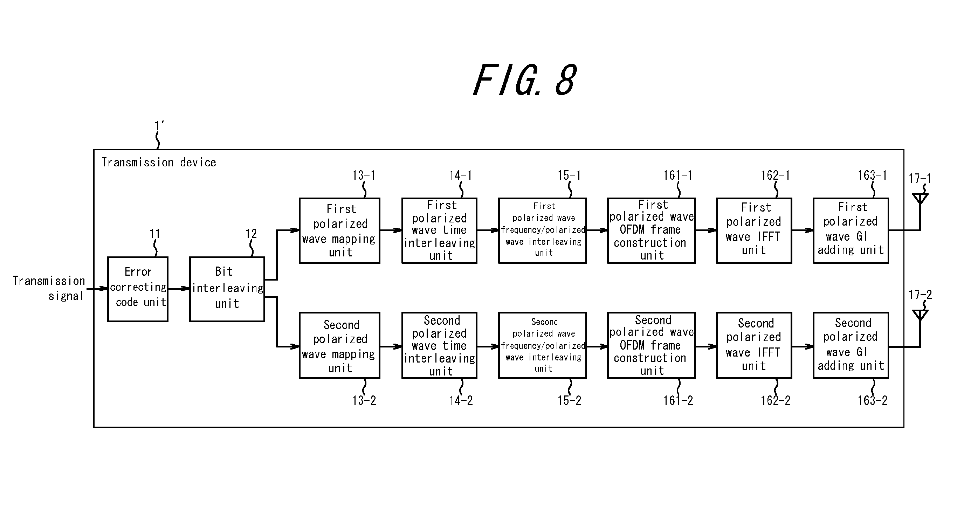

Here, as shown in FIG. 1, it should be noted that the frequency/polarized wave interleaving unit 15 does not perform interleaving on the bit data before mapping by the mapping unit 13, but rather on the carrier symbol after mapping by the mapping unit 13. The reason why is explained below. For the sake of comparison with the transmission device 1 according to the present invention, FIG. 8 illustrates the structure of a transmission device 1' that performs data distribution on the bit data before mapping by the mapping unit 13.

In an additive white Gaussian noise (AWGN) environment or the like, no characteristic difference particularly occurs when comparing interleaving between polarized waves performed on bit data before mapping, as in the transmission device 1', and on the carrier symbol after mapping, as in the transmission device 1. However, in a multipath environment, for example, distributing one carrier symbol at a time spreads out error-prone bits (for example, the two least significant bits in a Gray code in which adjacent carrier symbols differ by one bit) more than distributing one bit at a time. Therefore, the transmission device 1 according to the present invention does not distribute one bit at a time, like the transmission device 1', but rather distributes one carrier symbol at a time. The BER characteristics in a multipath environment can thus be improved.

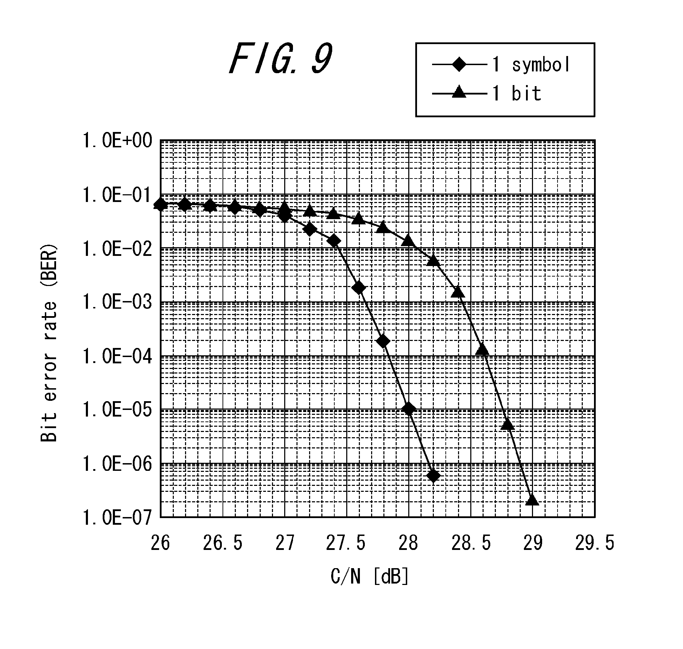

FIG. 9 shows BER simulation results for the transmission device 1 and the transmission device 1' when the frequency/polarized wave interleaving unit 15 operates as in the above-described first example in a multipath environment. The parameters used during the simulation were a multipath signal delay difference of 1.17 us, a D/U ratio of 6 dB, and a phase difference of 180°, with a modulation level of 1024 QAM. Other parameters were in conformance with ISDB-T mode 3.

[Second example of interleaving]

Next, a second example of interleaving is described. In the second example of interleaving, the structure of the frequency/polarized wave interleaving unit 15 is the same as the example in FIG. 4. However, whereas interleaving was performed in units of carrier symbols in the first example, interleaving in the second example is performed in units of data along the I coordinate axis in the IQ plane (referred to below as "I data") and data along the Q coordinate axis in the IQ plane (referred to below as "Q data").

The data distribution unit 151 resolves one carrier symbol input from the time interleaving unit 14 into I data and Q data and distributes a predetermined amount of data at a time with I data and Q data as a minimum unit (referred to below as "IQ data") to the first polarized wave frequency interleaving unit 150-1 and the second polarized wave frequency interleaving unit 150-2. In order to increase the interleaving effect, the data distribution unit 151 preferably distributes one set of IQ data at a time, i.e. I data to the first polarized wave frequency interleaving unit 150-1 and Q data to the second polarized wave frequency interleaving unit 150-2.

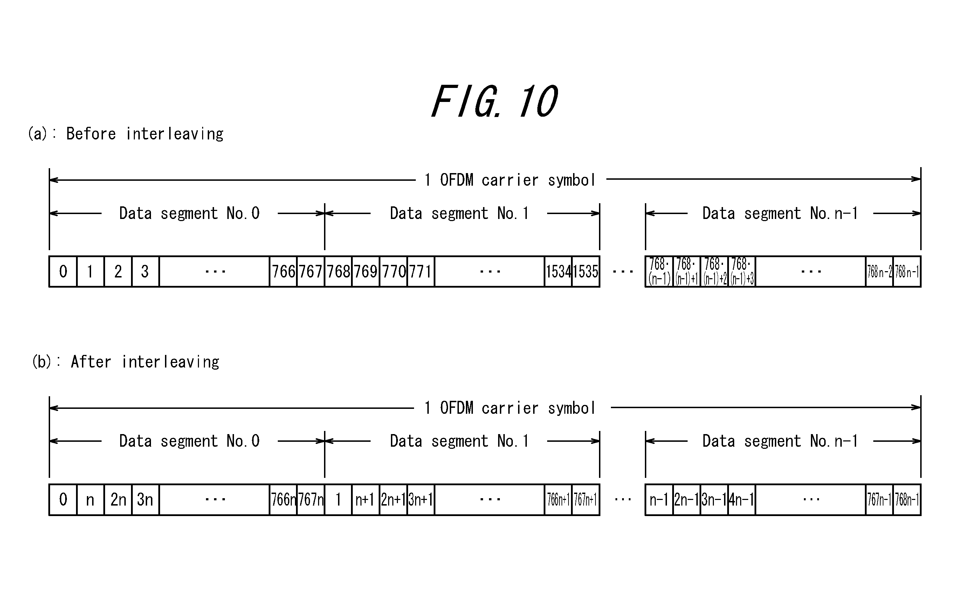

FIG. 10 illustrates processing by the inter-segment interleaving units 152, with FIG. 10(a) representing I data or Q data allocation before interleaving and FIG. 10(b) representing IQ data allocation after interleaving. The inter-segment interleaving units 152 interleave the IQ data input from the data distribution unit 151 between segments in the frequency domain one OFDM carrier symbol at a time. The data in FIG. 10 is I data in the case of the first polarized wave frequency interleaving unit 150-1 and Q data in the case of the second polarized wave frequency interleaving unit 150-2. In the example shown in FIG. 10, the number of segments in one OFDM symbol is n (where n = 13 with the ISDB-T system), and the number of carrier symbols per segment is 384 (i.e. the number of IQ data sets is 768). The inter-segment interleaving units 152 do not reorder data one carrier symbol at a time, but rather one IQ data set at a time. Note that this reordering is only a non-limiting example.

The data rotation units 153 interleave the IQ data input from the inter-segment interleaving units 152 one segment at a time by data rotation. The first polarized wave data rotation unit 153-1 reorders the data in the $x^{th}$ position of the $k^{th}$ segment to the $x'^{th}$ position of the $k^{th}$ segment by data rotation. The second polarized wave data rotation unit 153-2 reorders the data in the $y^{th}$ position of the $k^{th}$ segment to the $y'^{th}$ position of the $k^{th}$ segment by data rotation. For example, when the number of carrier symbols per segment is 384, then x' = (x + k) mod 384, and y' = (y - k) mod 384. When y' is negative, however, then 384 is added to the value of y'. Note that this rotation is only a non-limiting example. Furthermore, both the first polarized wave data rotation unit 153-1 and the second polarized wave data rotation unit 153-2 may perform rotation with the same equation.

The data randomization units 154 store, in advance at the transmitting side and the receiving side, a random number table for the number of carrier symbols within a segment and randomly reorder the carrier symbols input from the data rotation units 153 within each segment by referring to the random number table, thereby eliminating periodicity. The first polarized wave data randomization unit 154-1 and the second polarized wave data randomization unit 154-2 may use separate random number tables.

[Third example of interleaving]

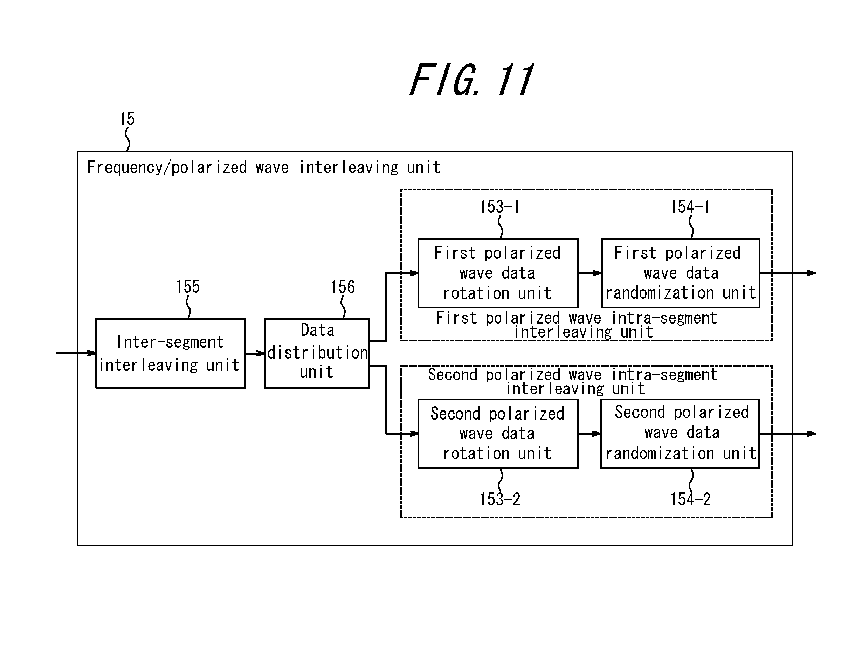

Next, a third example of interleaving is described. FIG. 11 is a block diagram showing the structure of the frequency/polarized wave interleaving unit 15 in the third example of interleaving. In the third example, the frequency/polarized wave interleaving unit 15 includes an inter-segment interleaving unit 155, a data distribution unit 156, the first polarized wave data rotation unit 153-1, the second polarized wave data rotation unit 153-2, the first polarized wave data randomization unit 154-1, and the second polarized wave data randomization unit 154-2.

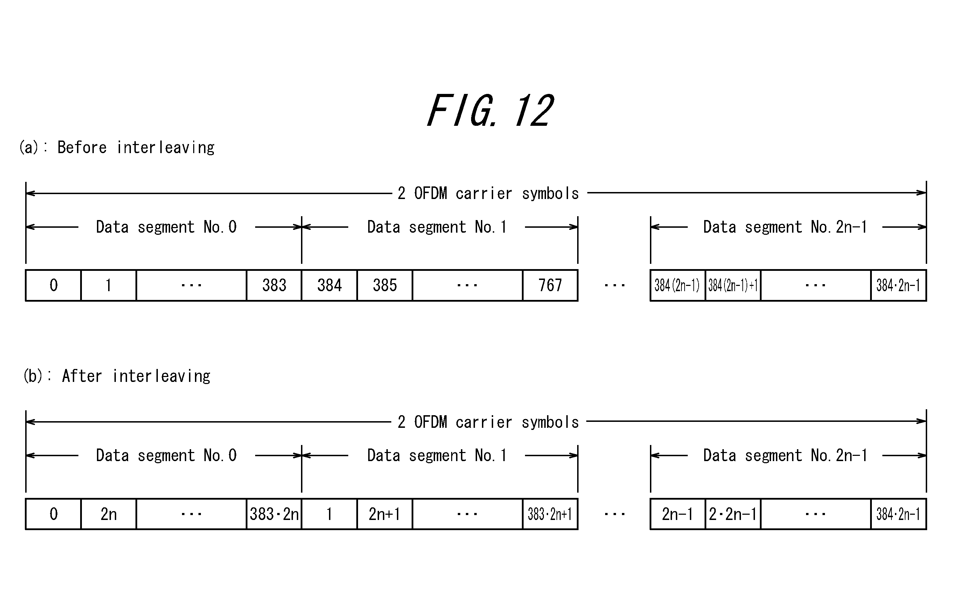

FIG. 12 illustrates processing by the inter-segment interleaving unit 155, with FIG. 12(a) representing the symbol allocation before interleaving and FIG. 12(b) representing the symbol allocation after interleaving. The inter-segment interleaving unit 155 interleaves the carrier symbols input from the time interleaving unit 14 between segments in the frequency domain a number of OFDM carrier symbols at a time equal to the number of transmit antennas. In the example shown in FIG. 12, the number of transmit antennas is two, the number of segments in two OFDM carrier symbols is 2n (where n = 13 with the ISDB-T system), and the number of carrier symbols per segment is 384. Note that this reordering is only a non-limiting example.

The data distribution unit 156 outputs the carrier symbols for interleaved segments No. 0 to n - 1 input from the inter-segment interleaving unit 155 to the first polarized wave data rotation unit 153-1 and outputs the data for segments No. n to 2n - 1 to the second polarized wave data rotation unit 153-2. Note that this distribution of carrier symbols is only a non-limiting example.

Processing by the intra-segment interleaving units (the data rotation units 153 and the data randomization units 154) is the same as in the first example of interleaving, and therefore a description thereof is omitted.

[Fourth example of interleaving]

Next, a fourth example of interleaving is described. In the fourth example of interleaving, the structure of the frequency/polarized wave interleaving unit 15 is the same as in the third example illustrated in FIG. 11. However, whereas interleaving was performed in units of carrier symbols in the third example, interleaving in the fourth example is performed in units of IQ data.

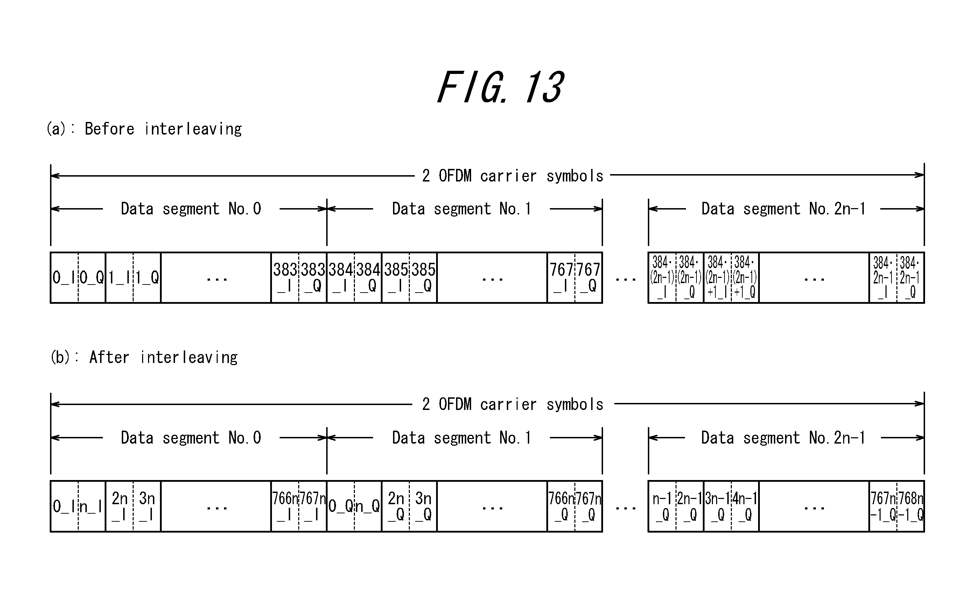

FIG. 13 illustrates processing by the inter-segment interleaving unit 155, with FIG. 13(a) representing the symbol allocation before interleaving and FIG. 13(b) representing the symbol allocation after interleaving. The inter-segment interleaving unit 155 resolves a carrier symbol input from the time interleaving unit 14 into IQ data and interleaves the carrier symbol between segments in the frequency domain a number of OFDM carrier symbols at a time equal to the number of transmit antennas, with IQ data as a minimum unit. In the example shown in FIG. 13, the number of transmit antennas is two, the number of segments in two OFDM symbols is 2n (where n = 13 with the ISDB-T system), and the number of carrier symbols per segment is 384. Note that this reordering is only a non-limiting example. After interleaving, only I data or Q data is gathered in each segment, thus forming a new carrier symbol (a pair of I and Q data).

The data distribution unit 156 outputs the IQ data for interleaved segments No. 0 to n - 1 input from the inter-segment interleaving unit 155 to the first polarized wave data rotation unit 153-1 and outputs the IQ data for segments No. n to 2n - 1 to the second polarized wave data rotation unit 153-2. Note that this distribution of IQ data is only a non-limiting example.

Processing by the intra-segment interleaving units (the data rotation units 153 and the data randomization units 154) is the same as in the second example of interleaving, and therefore a description thereof is omitted.

[Fifth example of interleaving]

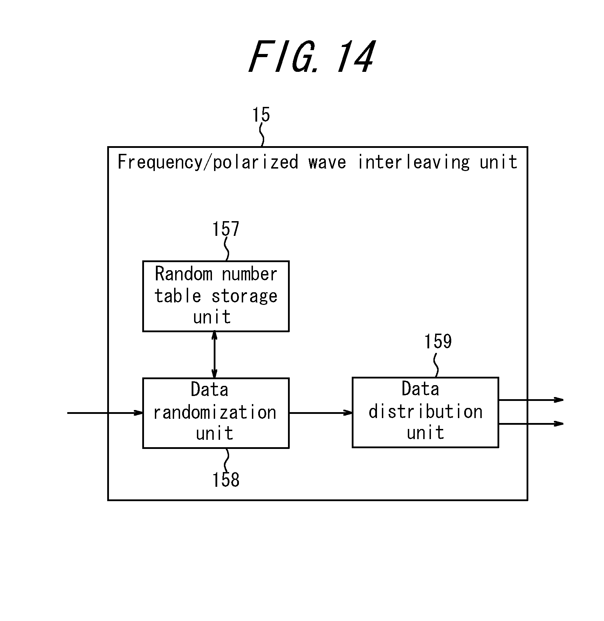

Next, a fifth example of interleaving is described. In the fifth example of interleaving, the frequency/polarized wave interleaving unit 15 randomly reorders all of the carrier symbols for the number of transmit antennas. FIG. 14 is a block diagram showing the structure of the frequency/polarized wave interleaving unit 15 in the fifth example. As illustrated in FIG. 14, the frequency/polarized wave interleaving unit 15 includes a random number table storage unit 157, a data randomization unit 158, and a data distribution unit 159.

The random number table storage unit 157 stores a random number table (the same random number table at the transmitting side and the receiving side) for determining allocation of a number of OFDM carrier symbols equal to the number of transmit antennas.

The data randomization unit 158 reorders the carrier symbols input from the time interleaving unit 14 a number of OFDM carrier symbols at a time equal to the number of transmit antennas by referring to the random number table storage unit 157.

The data distribution unit 159 distributes a predetermined number at a time of interleaved carrier symbols, input from the data randomization unit 158, to the first polarized wave output processing unit 16-1 and the second polarized wave output processing unit 16-2.

[Sixth example of interleaving]

Next, a sixth example of interleaving is described. In the sixth example of interleaving, the frequency/polarized wave interleaving unit 15 randomly reorders all of the IQ data for the number of transmit antennas. The structure of the frequency/polarized wave interleaving unit 15 in the sixth example is the same as in the fifth example illustrated in FIG. 14. However, whereas interleaving was performed in units of carrier symbols in the fifth example, interleaving in the sixth example is performed in units of IQ data.

The data randomization unit 158 resolves carrier symbols input from the time interleaving unit 14 into IQ data and reorders the carrier symbols a number of OFDM carrier symbols at a time equal to the number of transmit antennas by referring to the random number table storage unit 157, with IQ data as a minimum unit.

The data distribution unit 159 distributes a predetermined amount at a time of interleaved IQ data, input from the data randomization unit 158, to the first polarized wave output processing unit 16-1 and the second polarized wave output processing unit 16-2.

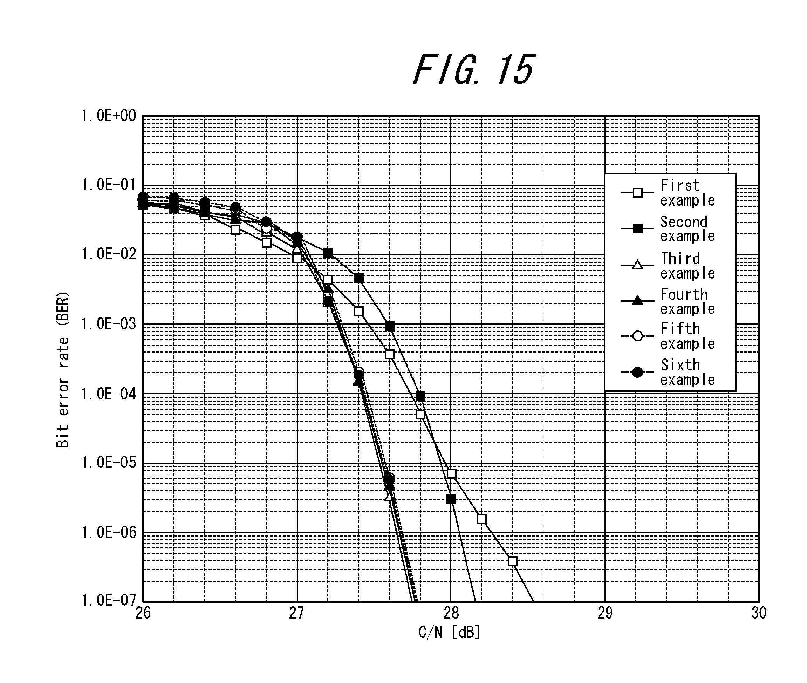

FIG. 15 shows simulation results for the transmission device 1, illustrating the BER characteristics for the above-described first through sixth examples of interleaving. The simulation was performed for the case of the first polarized wave being a horizontal polarized wave and the second polarized wave being a vertical polarized wave, with a power difference of 6 dB between the two. The modulation scheme was 1024 QAM, the code rate was 3/4, and the GI ratio was 1/8. The bandwidth, total number of carriers, and the like were in conformance with mode 3 of ISDB-T. Zero Forcing (ZF) was applied to the MIMO demodulation algorithm, and with an LDPC code length of 64800, the number of decoding iterations by sum-product decoding was 20.

Note that in the fifth and sixth examples of interleaving, periodicity can be removed by a single process, and the BER characteristics are good. The random number table is large, however, thus increasing the burden when implemented in hardware.

In this way, the transmission device 1 uses the frequency/polarized wave interleaving unit 15 to reorder carrier symbols in the frequency domain and between polarized waves, thereby generating interleaved data for each transmission antenna. Furthermore, the reception device 2 uses the first frequency/polarized wave deinterleaving unit 25 and the second frequency/polarized wave deinterleaving unit 27 to deinterleave, in the frequency domain and between polarized waves, the data interleaved by the transmission device 1. Therefore, according to the transmission device 1 and the reception device 2 of Embodiment 1, data for one polarized wave that includes a large amount of erroneous data can be dispersed even when a difference in reception level exists between the polarized waves. Hence, the effect of the error correcting code can be enhanced, and the BER characteristics can be improved.

<Embodiment 2>

Next, in Embodiment 2, the case of transmitting one data stream simultaneously over a plurality of channels (referred to below as bulk transmission) is described, i.e. the case of the transmission device using a plurality of transmit antennas per channel to transmit an OFDM signal over a plurality of channels and the reception device using a plurality of receive antennas per channel to receive the OFDM signal over a plurality of channels. Embodiment 2 describes an example in which the number of channels is two, yet the number of channels is not limited to two.

[Transmission device]

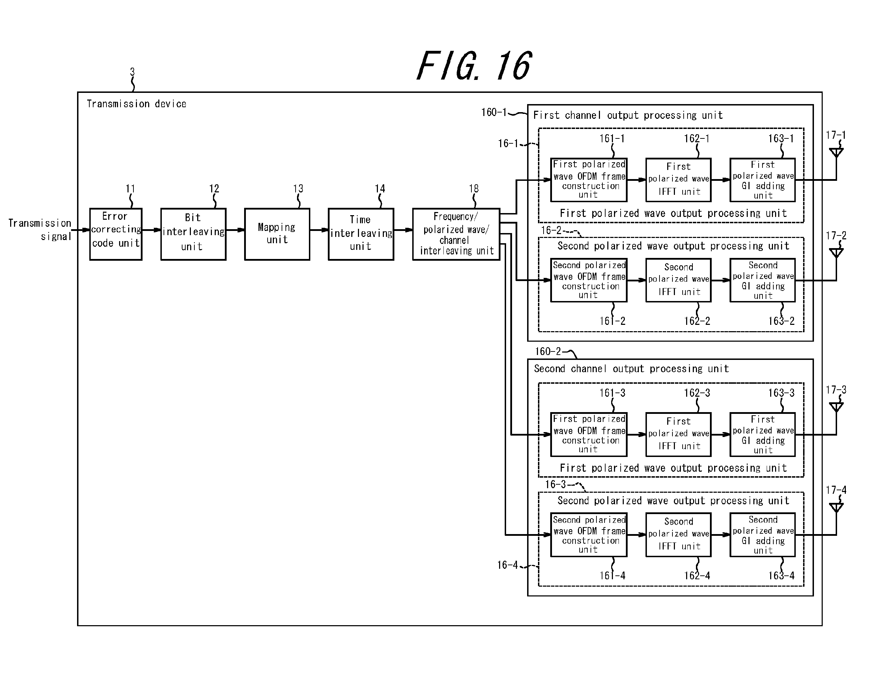

FIG. 16 is a block diagram illustrating the structure of a transmission device 3 according to Embodiment 2 of the present invention. The error correcting code unit 11, bit interleaving unit 12, mapping unit 13, and time interleaving unit 14 perform the same processing as Embodiment 1 for the transmission signals over two channels.

A frequency/polarized wave/channel interleaving unit 18 reorders, in the frequency domain, and between polarized waves and channels (between transmit antennas), the carrier symbols for two channels that are input from the time interleaving unit 14 and have been interleaved in the time domain, thereby generating interleaved data for each transmit antenna 17. In Embodiment 2, the number of transmit antennas is four, and thus the frequency/polarized wave/channel interleaving unit 18 divides the carrier symbols into four streams and outputs the result. Specific examples of interleaving are described below.

The output processing unit 16 performs the same processing as Embodiment 1 for OFDM frame construction, IFFT, and GI addition on each stream output from the frequency/polarized wave/channel interleaving unit 18. The transmission device 3 transmits the OFDM signal of the first channel from transmit antennas 17-1 and 17-2 and the OFDM signal of the second channel from transmit antennas 17-3 and 17-4.

[Reception device]

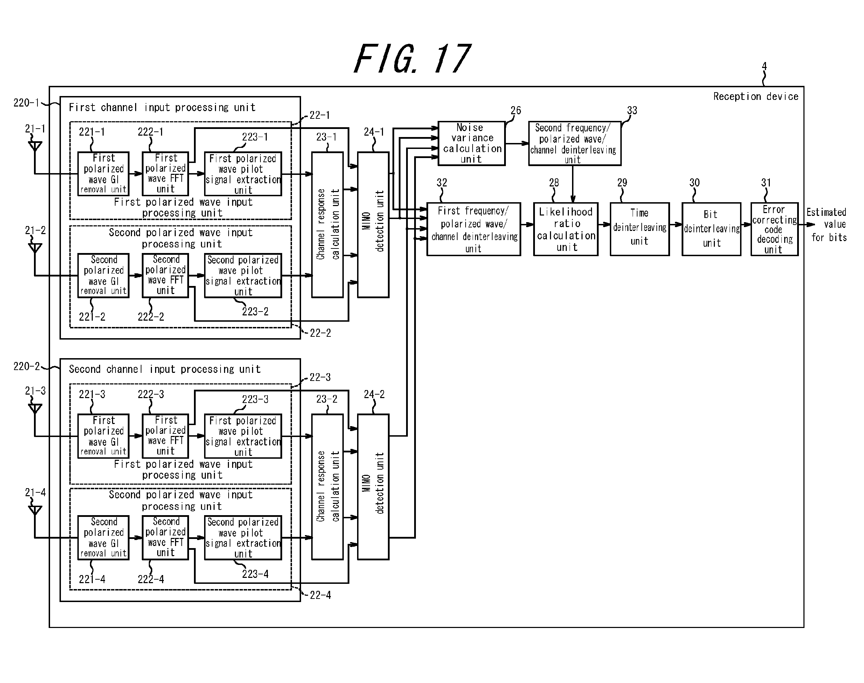

Next, the reception device according to Embodiment 2 is described. FIG. 17 is a block diagram illustrating the structure of the reception device according to Embodiment 2 of the present invention. The reception device 4 receives the OFDM signal of the first channel transmitted from the transmit antennas 17-1 and 17-2 of the transmission device 3 with receive antennas 21-1 and 21-2 and receives the OFDM signal of the second channel transmitted from the transmit antennas 17-3 and 17-4 of the transmission device 3 with receive antennas 21-3 and 21-4. In other words, the transmission device 3 and the reception device 4 achieve 2 x 2 MIMO transmission for the number of channels.

For the OFDM signals received by the receive antennas 21, the input processing units 22 each perform processing as in Embodiment 1 for GI removal, FFT, and pilot signal extraction.

A channel response calculation unit 23-1 and a MIMO detection unit 24-1 calculate the channel response for the received signal of the first channel, processed by a first channel input processing unit 220-1, and perform waveform equalization and isolation. A channel response calculation unit 23-2 and a MIMO detection unit 24-2 calculate the channel response for the received signal of the second channel, processed by a second channel input processing unit 220-2, and perform waveform equalization and isolation.

A first frequency/polarized wave/channel deinterleaving unit 32 and a second frequency/polarized wave/channel deinterleaving unit 33 reorder data in the reverse direction from the frequency/polarized wave/channel interleaving unit 18 to restore the data to the original order. Since the block diagram of the below-described frequency/polarized wave/channel interleaving unit 18 and the direction of signal line arrows are simply reversed, a description is omitted. The noise variance calculation unit 26, likelihood ratio calculation unit 28, time deinterleaving unit 29, bit deinterleaving unit 30, and error correcting code decoding unit 31 perform the same processing as Embodiment 1 for the received signals over two channels.

[Frequency/polarized wave/channel interleaving unit]

Next, the frequency/polarized wave/channel interleaving unit 18 is described. As in Embodiment 1, the first example of interleaving through the sixth example of interleaving are described for Embodiment 2 as well.

[First example of interleaving]

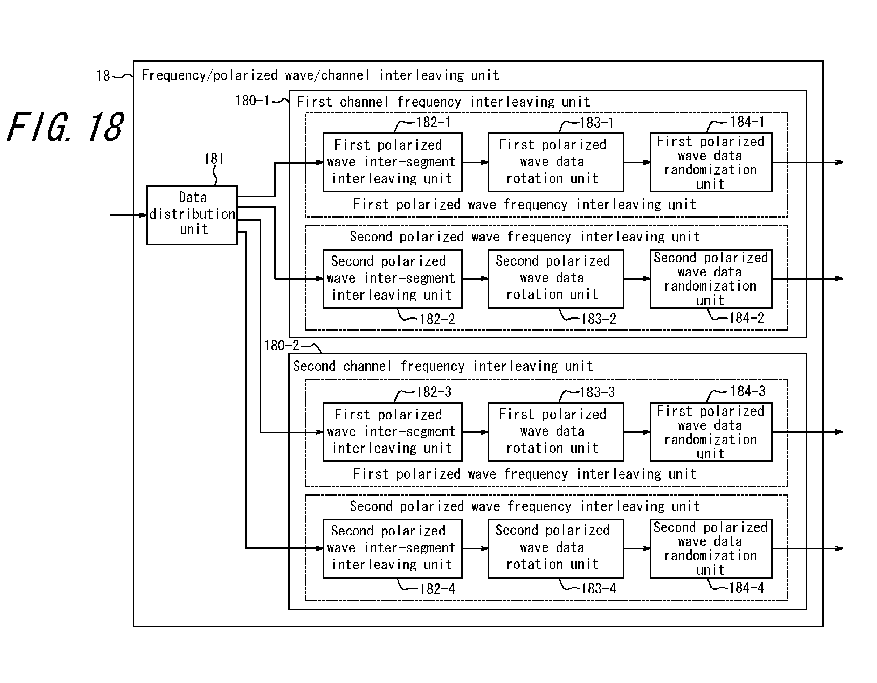

In the first example of interleaving, the frequency/polarized wave/channel interleaving unit 18 performs frequency interleaving after classifying a predetermined number of carrier symbols at a time into first polarized wave transmission data for the first channel, second polarized wave transmission data for the first channel, first polarized wave transmission data for the second channel, and second polarized wave transmission data for the second channel. FIG. 18 is a block diagram showing the structure of the first example of the frequency/polarized wave/channel interleaving unit 18. In the first example, the frequency/polarized wave/channel interleaving unit 18 includes a data distribution unit 181, a first channel frequency interleaving unit 180-1, and a second channel frequency interleaving unit 180-2.
The data distribution unit 181 divides a predetermined number of carrier symbols, input from the time interleaving unit 14, at a time into four streams and distributes the streams to a first polarized wave frequency interleaving unit for the first channel, a second polarized wave frequency interleaving unit for the first channel, a first polarized wave frequency interleaving unit for the second channel, and a second polarized wave frequency interleaving unit for the second channel. In order to increase the interleaving effect, the data distribution unit 181 preferably distributes carrier symbols one at a time. In Embodiment 2, inter-segment interleaving, data rotation, and data randomization are performed on the four streams output from the data distribution unit 181. The processing for each stream is identical to the first example in Embodiment 1, and therefore a description is omitted.

[Second example of interleaving]

Next, a second example of interleaving is described. In the second example of interleaving, the structure of the frequency/polarized wave/channel interleaving unit 18 is the same as the example in FIG. 18. However, whereas interleaving was performed in units of carrier symbols in the first example, interleaving in the second example is performed in units of I data or Q data.
The data distribution unit 181 resolves a carrier symbol input from the time interleaving unit 14 into I data and Q data, divides a predetermined amount of data at a time into four streams with IQ data as the minimum unit, and distributes the streams to the first polarized wave frequency interleaving unit for the first channel, the second polarized wave frequency interleaving unit for the first channel, the first polarized wave frequency interleaving unit for the second channel, and the second polarized wave frequency interleaving unit for the second channel. In order to increase the interleaving effect, the data distribution unit 181 preferably distributes one set of IQ data at a time. In Embodiment 2, inter-segment interleaving, data rotation, and data randomization are performed on the four streams output from the data distribution unit 181. The processing for each stream is identical to the second example in Embodiment 1, and therefore a description is omitted.

[Third example of interleaving]

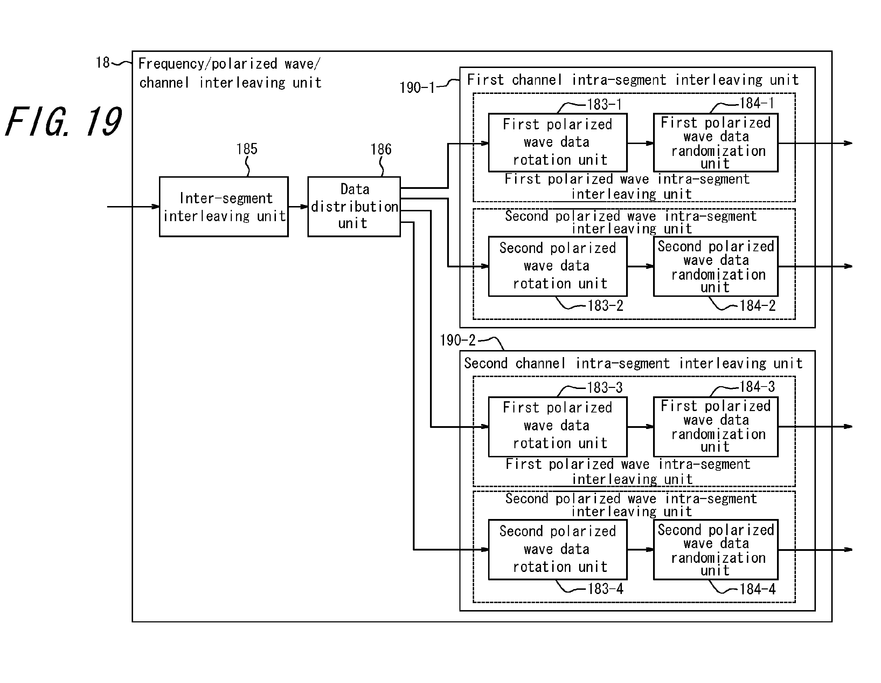

Next, a third example of interleaving is described. FIG. 19 is a block diagram showing the structure of the frequency/polarized wave/channel interleaving unit 18 in the third example of interleaving. In the third example, the frequency/polarized wave/channel interleaving unit 18 includes an inter-segment interleaving unit 185, a data distribution unit 186, a first channel intra-segment interleaving unit 190-1, and a second channel intra-segment interleaving unit 190-2.

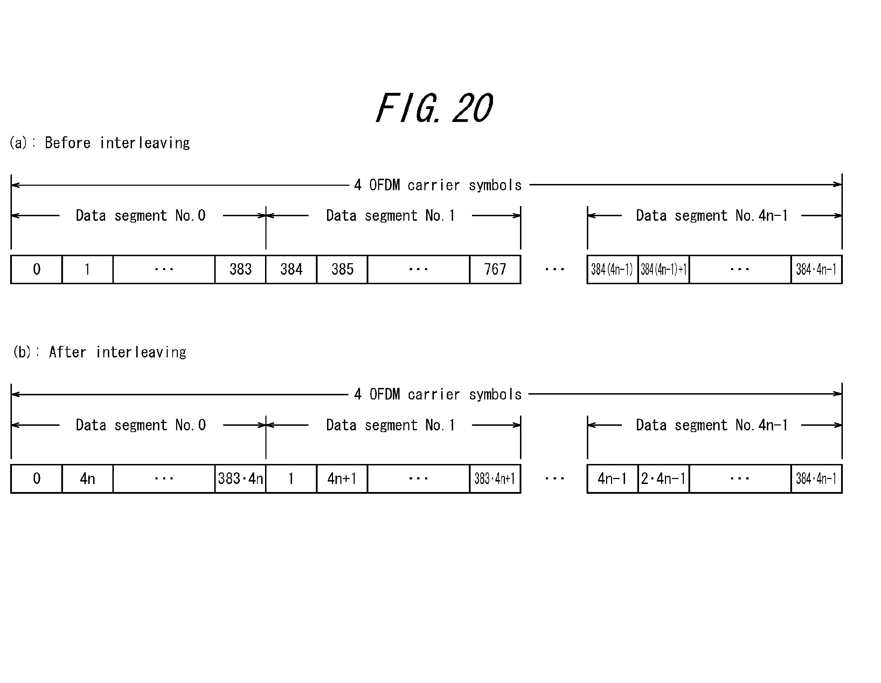

FIG. 20 illustrates processing by the inter-segment interleaving unit 185, with FIG. 20(a) representing the symbol allocation before interleaving and FIG. 20(b) representing the symbol allocation after interleaving. The inter-segment interleaving unit 185 interleaves the carrier symbols input from the time interleaving unit 14 between segments in the frequency domain a number of OFDM carrier symbols at a time equal to the number of transmit antennas. In the example shown in FIG. 20, the number of transmit antennas is four, the number of segments in four OFDM carrier symbols is 4n (where n = 13 with the ISDB-T system), and the number of carrier symbols per segment is 384. Note that this reordering is only a non-limiting example.

The data distribution unit 186 outputs the carrier symbols for interleaved segments No. 0 to n - 1 input from the inter-segment interleaving unit 185 to a first polarized wave data rotation unit 183-1 for the first channel, outputs the data for segments No. n to 2n - 1 to a second polarized wave data rotation unit 183-2 for the first channel, outputs the data for segments No. 2n to 3n - 1 to a first polarized wave data rotation unit 183-3 for the second channel, and outputs the data for segments No. 3n to 4n - 1 to a second polarized wave data rotation unit 183-4 for the second channel. Note that this distribution of carrier symbols is only a non-limiting example.

Processing by the intra-segment interleaving units (the data rotation units 183 and the data randomization units 184) is the same as in the first example of interleaving, and therefore a description thereof is omitted.

[Fourth example of interleaving]

Next, a fourth example of interleaving is described. In the fourth example of interleaving, the structure of the frequency/polarized wave/channel interleaving unit 18 is the same as in the third example illustrated in FIG. 19. However, whereas interleaving was performed in units of carrier symbols in the third example, interleaving in the fourth example is performed in units of IQ data.

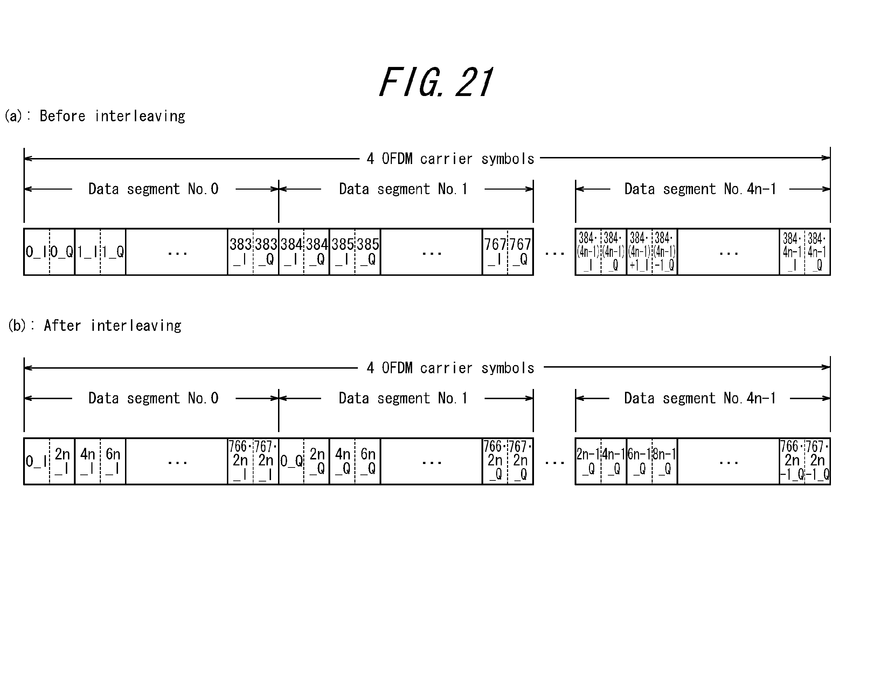

FIG. 21 illustrates processing by the inter-segment interleaving unit 185, with FIG. 21(a) representing the symbol allocation before interleaving and FIG. 21(b) representing the symbol allocation after interleaving. The inter-segment interleaving unit 185 resolves a carrier symbol input from the time interleaving unit 14 into IQ data and interleaves the carrier symbol between segments in the frequency domain a number of OFDM carrier symbols at a time equal to the number of transmit antennas, with IQ data as a minimum unit. In the example shown in FIG. 21, the number of transmit antennas is four, the number of segments in four OFDM symbols is 4n (where n = 13 with the ISDB-T system), and the number of carrier symbols per segment is 384. Note that this reordering is only a non-limiting example. After interleaving, only I data or Q data is gathered in each segment, thus forming a new carrier symbol (a pair of I and Q data).

The data distribution unit 186 outputs the carrier symbols for interleaved segments No. 0 to n - 1 input from the inter-segment interleaving unit 185 to the first polarized wave data rotation unit 183-1 for the first channel, outputs the data for segments No. n to 2n - 1 to the second polarized wave data rotation unit 183-2 for the first channel, outputs the data for segments No. 2n to 3n - 1 to the first polarized wave data rotation unit 183-3 for the second channel, and outputs the data for segments No. 3n to 4n - 1 to the second polarized wave data rotation unit 183-4 for the second channel. Note that this distribution of IQ data is only a non-limiting example.

Processing by the intra-segment interleaving units (the data rotation units 183 and the data randomization units 184) is the same as in the second example of interleaving, and therefore a description thereof is omitted.

[Fifth example of interleaving]

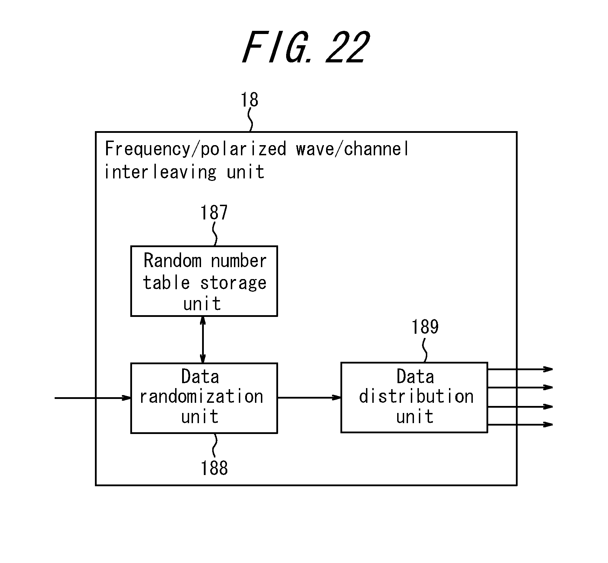

Next, a fifth example of interleaving is described. In the fifth example of interleaving, the frequency/polarized wave/channel interleaving unit 18 randomly reorders all of the carrier symbols for the number of transmit antennas. FIG. 22 is a block diagram showing the structure of the frequency/polarized wave/channel interleaving unit 18 in the fifth example of interleaving. As illustrated in FIG. 22, the frequency/polarized wave/channel interleaving unit 18 includes a random number table storage unit 187, a data randomization unit 188, and a data distribution unit 189.

The random number table storage unit 187 stores a random number table (the same random number table at the transmitting side and the receiving side) for determining allocation of a number of OFDM carrier symbols equal to the number of transmit antennas.

The data randomization unit 188 reorders the carrier symbols input from the time interleaving unit 14 a number of OFDM carrier symbols at a time equal to the number of transmit antennas by referring to the random number table storage unit 187.

The data distribution unit 189 divides a predetermined number at a time of interleaved carrier symbols, input from the data randomization unit 188, into four streams and distributes the streams to the first polarized wave output processing unit 16-1 for the first channel, the second polarized wave output processing unit 16-2 for the first channel, the first polarized wave output processing unit 16-3 for the second channel, and the second polarized wave output processing unit 16-4 for the second channel.

[Sixth example of interleaving]

Next, a sixth example of interleaving is described. In the sixth example of interleaving, the frequency/polarized wave/channel interleaving unit 18 randomly reorders all of the IQ data for the number of transmit antennas. The structure of the frequency/polarized wave/channel interleaving unit 18 in the sixth example is the same as in the fifth example illustrated in FIG. 22. However, whereas interleaving was performed in units of carrier symbols in the fifth example, interleaving in the sixth example is performed in units of IQ data.

The data randomization unit 188 resolves carrier symbols input from the time interleaving unit 14 into IQ data and reorders the carrier symbols a number of OFDM carrier symbols at a time equal to the number of transmit antennas by referring to the random number table storage unit 187, with IQ data as a minimum unit.

The data distribution unit 189 distributes a predetermined amount at a time of interleaved IQ data, input from the data randomization unit 188, to the first polarized wave output processing unit 16-1 for the first channel, the second polarized wave output processing unit 16-2 for the first channel, the first polarized wave output processing unit 16-3 for the second channel, and the second polarized wave output processing unit 16-4 for the second channel.

In this way, the transmission device 3 uses the frequency/polarized wave/channel interleaving unit 18 to reorder carrier symbols for a plurality of channels in the frequency domain and between polarized waves to generate interleaved data for each transmission antenna and transmits an OFDM signal over a plurality of channels. Furthermore, the reception device 4 receives the OFDM signal over a plurality of channels and uses the first frequency/polarized wave/channel deinterleaving unit 32 and the second frequency/polarized wave/channel deinterleaving unit 33 to deinterleave, in the frequency domain and between polarized waves, the data for the plurality of channels interleaved by the transmission device 3. Therefore, according to the transmission device 3 and the reception device 4 of Embodiment 2, data for one polarized wave that includes a large amount of erroneous data can be dispersed even when a difference in reception level exists between the polarized waves, like Embodiment 1, when performing bulk transmission using a plurality of channels. Furthermore, even when co-channel interference occurs for only one of the channels, the data for the one channel that includes a large amount of erroneous data can be dispersed. As a result, the effect of the error correcting code can be enhanced, and the BER characteristics can be improved.

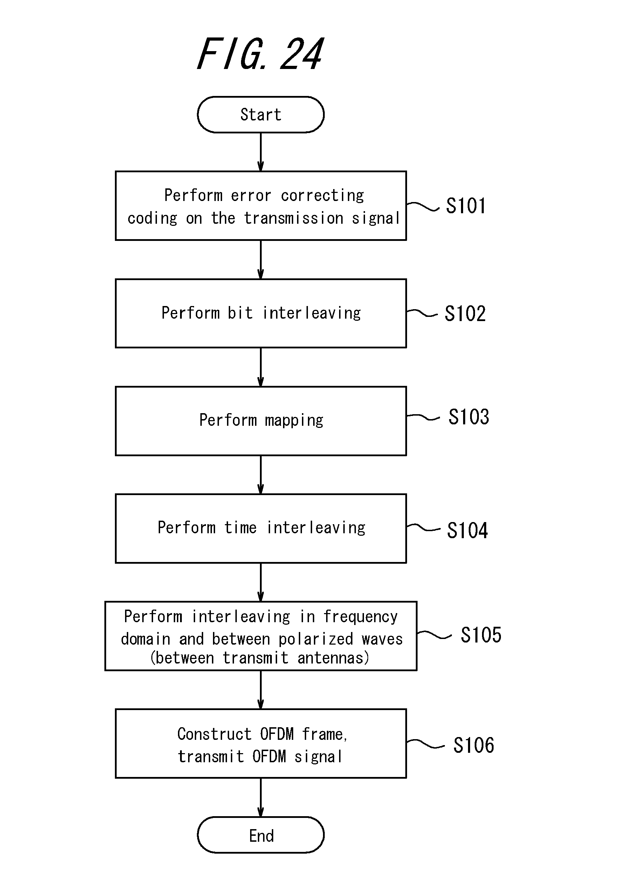

FIG. 24 is a flowchart showing a transmission method for the above-described transmission devices 1 and 3. The transmission method is described concisely with reference to FIG. 24. First, the error correcting code unit 11 performs error correcting coding on the transmission signal (step S101). Next, the bit interleaving unit 12 interleaves the error correction coded transmission signal bit by bit (step S102). The mapping unit 13 then performs mapping onto the IQ plane to generate carrier symbols that are carrier modulated in accordance with a modulation scheme (step S103). Next, the time interleaving unit 14 reorders the carrier symbols in the time domain (step S104). The frequency/polarized wave interleaving unit 15 or 18 then reorders, in the frequency domain and between polarized waves (between transmit antennas), the carrier symbols interleaved in the time domain, thereby generating interleaved data for each transmit antenna 17 (step S105). Details on the interleaving by the frequency/polarized wave interleaving unit 15 or 18 are as described above. Finally, the output processing units 16 construct an OFDM frame for the interleaved data and transmit OFDM signals via the transmit antennas 17 (step S106).

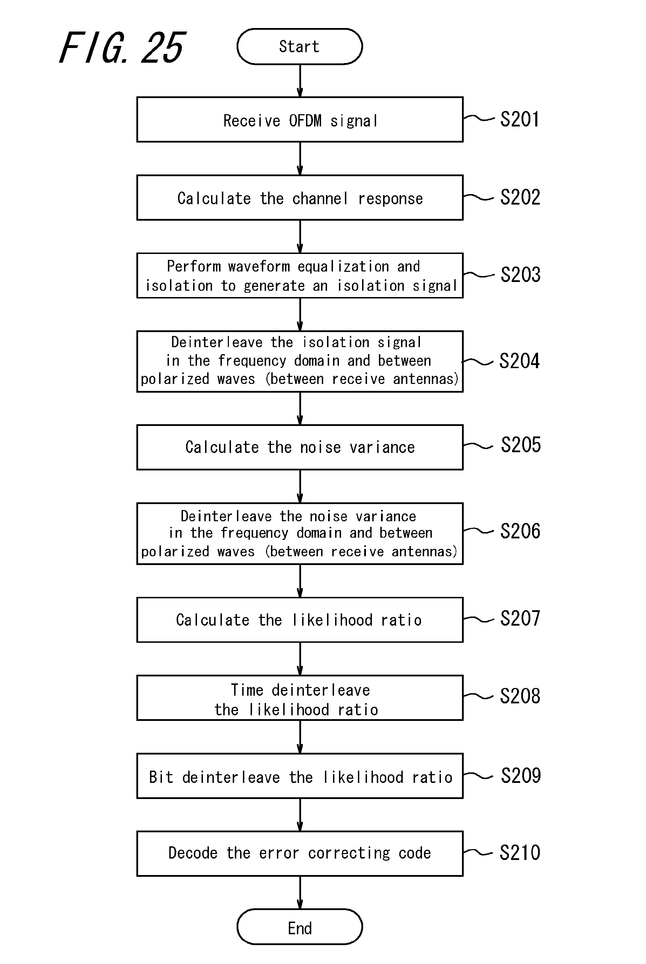

FIG. 25 is a flowchart showing a reception method for the above-described reception devices 2 and 4. The reception method is described concisely with reference to FIG. 25. First, the input processing units 22 receive OFDM signals via the receive antennas 21 (step S201). Next, the channel response calculation unit 23 calculates the channel response (step S202). The MIMO detection unit 24 then performs waveform equalization and isolation on the received OFDM signal using the channel response to generate an isolation signal (step S203). The first frequency/polarized wave deinterleaving unit 25 or the first frequency/polarized wave/channel deinterleaving unit 32 then deinterleaves the isolation signal in the frequency domain and between polarized waves (between receive antennas) (step S204). Next, the noise variance calculation unit 26 calculates the noise variance $\sigma^2$ from the polarized wave signals (step S205), and the second frequency/polarized wave deinterleaving unit 27 or the second frequency/polarized wave/channel deinterleaving unit 33 deinterleaves the noise variance $\sigma^2$ in the frequency domain and between polarized waves (between receive antennas) (step S206).

Subsequently, the likelihood ratio calculation unit 28 calculates a likelihood ratio $\lambda$ using the data deinterleaved in step S204 and the noise variance $\sigma^2$ deinterleaved in step S206 (step S207). Next, the time deinterleaving unit 29 time deinterleaves the likelihood ratio $\lambda$ (step S208), and the bit deinterleaving unit 30 bit deinterleaves the time deinterleaved likelihood ratio $\lambda$ (step S209). Finally, the error correcting code decoding unit 31 decodes the error correcting code using the bit deinterleaved likelihood ratio $\lambda$ (step S210).

In the above-described embodiments, representative examples have been described, yet it is to be noted that many modifications and substitutions within the scope and spirit of the present invention will be apparent to a person of ordinary skill in the art. Accordingly, the present invention is not limited to the above-described embodiments but rather may be modified or altered in a variety of ways without deviating from the scope of the present invention.

For example, the error correcting code unit 11 in the transmission device 1 of the above-described embodiment has been described as using an LDPC code as the inner code, yet when not using an LDPC code as the inner code, the reception device 2 need not be provided with the noise variance calculation unit 26, second frequency/polarized wave deinterleaving unit 27, and likelihood ratio calculation unit 28. Furthermore, in the above-described embodiments, a transmission device and reception device according to the present invention has been described for the case of 2 x 2 MIMO transmission, yet the present invention may of course also be applied to 2 x 4 or 4 x 4 MIMO transmission.

In the above-described embodiments, the transmission devices 1 and 3 have been described as being provided with the bit interleaving unit 12 and the time interleaving unit 14, yet these are not essential structures. It is also possible to provide only one of the two. Interleaving may also be performed by a plurality of blocks. For example, apart from the time interleaving unit 14, time interleaving may be performed by the frequency/polarized wave interleaving unit 15 or frequency/polarized wave/channel interleaving unit 18. Similarly, in the above-described embodiments, the reception devices 2 and 4 have been described as being provided with the time deinterleaving unit 29 and the bit deinterleaving unit 30, yet these are not essential structures. It is also possible to provide only one of the two. Deinterleaving may also be performed by a plurality of blocks. For example, apart from the time deinterleaving unit 29, time deinterleaving may be performed by the first frequency/polarized wave deinterleaving unit 25 and second frequency/polarized wave deinterleaving unit 27, or by the first frequency/polarized wave/channel deinterleaving unit 32 and second frequency/polarized wave/channel deinterleaving unit 33. Furthermore, the order of processing in the present invention is not limited to the order in the above-described embodiments. For example, in the reception devices 2 and 4, processing by the time deinterleaving unit 29 may precede processing by the likelihood ratio calculation unit 28.

INDUSTRIAL APPLICABILITY

The present invention is thus useful in a MIMO system that performs SDM-MIMO transmission.

REFERENCE SIGNS LIST

1, 3: Transmission device
2, 4: Reception device
11: Error correcting code unit
12: Bit interleaving unit
13: Mapping unit
14: Time interleaving unit
15: Frequency/polarized wave interleaving unit
16-1, 16-3: First polarized wave output processing unit
16-2, 16-4: Second polarized wave output processing unit
17-1, 17-3: First polarized wave transmit antenna
17-2, 17-4: Second polarized wave transmit antenna
18: Frequency/polarized wave/channel interleaving unit
21-1, 21-3: First polarized wave receive antenna
21-2, 21-4: Second polarized wave receive antenna
22-1: First polarized wave input processing unit
22-2: Second polarized wave input processing unit
23, 23-1, 23-2: Channel response calculation unit
24, 24-1, 24-2: MIMO detection unit
25: First frequency/polarized wave deinterleaving unit
26: Noise variance calculation unit
27: Second frequency/polarized wave deinterleaving unit
28: Likelihood ratio calculation unit
29: Time deinterleaving unit
30: Bit deinterleaving unit
31: Error correcting code decoding unit
32: First frequency/polarized wave/channel deinterleaving unit
33: Second frequency/polarized wave/channel deinterleaving unit
150-1: First polarized wave frequency interleaving unit
150-2: Second polarized wave frequency interleaving unit
151, 156, 159, 181, 186, 189: Data distribution unit
152-1, 182-1, 182-3: First polarized wave inter-segment interleaving unit
152-2, 182-2, 182-4: Second polarized wave inter-segment interleaving unit
153-1, 183-1, 183-3: First polarized wave data rotation unit
153-2, 183-2, 183-4: Second polarized wave data rotation unit
154-1, 184-1, 184-3: First polarized wave data randomization unit
154-2, 184-2, 184-4: Second polarized wave data randomization unit
155, 185: Inter-segment interleaving unit

157, 187: Random number table storage unit
158, 188: Data randomization unit
159, 189: Data distribution unit
160-1: First channel output processing unit
160-2: Second channel output processing unit
161-1, 161-3: First polarized wave OFDM frame construction unit
161-2, 161-4: Second polarized wave OFDM frame construction unit
162-1, 162-3: First polarized wave IFFT unit
162-2, 162-4: Second polarized wave IFFT unit
163-1, 163-3: First polarized wave GI adding unit
163-2, 163-4: Second polarized wave GI adding unit
180-1: First channel frequency interleaving unit
180-2: Second channel frequency interleaving unit
190-1: First channel intra-segment interleaving unit
190-2: Second channel intra-segment interleaving unit
220-1: First channel input processing unit
220-2: Second channel input processing unit
221-1, 221-3: First polarized wave GI removal unit
221-2, 221-4: Second polarized wave GI removal unit
222-1, 222-3: First polarized wave FFT unit
222-2, 222-4: Second polarized wave FFT unit
223-1, 223-3: First polarized wave pilot signal extraction unit
223-2, 223-4: Second polarized wave pilot signal extraction unit

**Claims**

1. A transmission device for transmitting an OFDM signal using a plurality of transmit antennas, comprising:

    a mapping unit configured to map a transmission signal onto an IQ plane to generate a carrier-modulated carrier symbol;
    a frequency/transmit antenna interleaving unit configured to interleave the carrier symbol in a frequency domain and between transmit antennas to generate interleaved data for each transmit antenna; and
    an output processing unit configured to construct an OFDM frame for the interleaved data for each transmit antenna and transmit an OFDM signal via the transmit antennas.

2. The transmission device according to claim 1, wherein
   the frequency/transmit antenna interleaving unit comprises:

    a data distribution unit configured to distribute the carrier symbol a predetermined number at a time to generate data for each transmit antenna; and
    a frequency interleaving unit configured to generate the interleaved data for each transmit antenna by interleaving the data for each transmit antenna in the frequency domain one OFDM carrier symbol at a time.

3. The transmission device according to claim 2, wherein the data distribution unit generates the data for each transmit antenna by resolving the carrier symbol into I data along an I coordinate axis in an IQ plane and Q data along a Q coordinate axis in the IQ plane and distributing a predetermined amount at a time, with the I data and the Q data as a minimum unit.

4. The transmission device according to claim 1, wherein
   the frequency/transmit antenna interleaving unit comprises:

    an inter-segment interleaving unit configured to generate data interleaved between segments by interleaving the carrier symbol in the frequency domain a number of OFDM carrier symbols at a time equal to a number of the transmit antennas; and
    a data distribution unit configured to generate the interleaved data for each transmit antenna by distributing the data interleaved between segments a predetermined amount at a time.

**5.** The transmission device according to claim 4, wherein the inter-segment interleaving unit generates the data interleaved between segments by resolving the carrier symbol into I data along an I coordinate axis in an IQ plane and Q data along a Q coordinate axis in the IQ plane and interleaving the I data and the Q data in the frequency domain a number of OFDM carrier symbols at a time equal to the number of the transmit antennas, with the I data and the Q data as a minimum unit.

**6.** The transmission device according to claim 1, wherein
the frequency/transmit antenna interleaving unit comprises:

a random number table storage unit configured to store a random number table for determining allocation of a number of OFDM carrier symbols, in the carrier-modulated data, equal to a number of the transmit antennas;
a data randomization unit configured to reorder the carrier symbol a number of OFDM carrier symbols at a time equal to the number of the transmit antennas by referring to the random number table; and
a data distribution unit configured to generate the interleaved data for each transmit antenna by distributing a predetermined number at a time of carrier symbols reordered by the data randomization unit.

**7.** The transmission device according to claim 6, wherein the data randomization unit resolves the carrier symbol into I data along an I coordinate axis in an IQ plane and Q data along a Q coordinate axis in the IQ plane and reorders the I data and Q data a number of OFDM carrier symbols at a time equal to the number of the transmit antennas, with the I data and the Q data as a minimum unit, by referring to the random number table.

**8.** A transmission device for transmitting an OFDM signal over a plurality of channels using a plurality of transmit antennas per channel, comprising:

a mapping unit configured to map transmission signals for the plurality of channels onto an IQ plane to generate carrier-modulated carrier symbols for the plurality of channels;
a frequency/transmit antenna interleaving unit configured to interleave the carrier symbols for the plurality of channels in a frequency domain and between transmit antennas to generate interleaved data for each transmit antenna; and
an output processing unit configured to construct an OFDM frame for the interleaved data for each transmit antenna and transmit an OFDM signal via the transmit antennas.

**9.** The transmission device according to any one of claims 1 through 8, wherein the output processing unit transmits the OFDM signal via a horizontal polarized wave antenna and a vertical polarized wave antenna, or via a right-handed circularly polarized wave antenna and a left-handed circularly polarized wave antenna.

**10.** A reception device for receiving an OFDM signal using a plurality of receive antennas, comprising:

a MIMO detection unit configured to generate an isolation signal by using a channel response to perform waveform equalization and isolation on an OFDM signal received by the plurality of receive antennas;
a first deinterleaving unit configured to deinterleave the isolation signal in a frequency domain and between receive antennas;
a noise variance calculation unit configured to calculate a noise variance of the OFDM signal;
a second deinterleaving unit configured to deinterleave the noise variance in the frequency domain and between receive antennas;
a likelihood ratio calculation unit configured to calculate a likelihood ratio using the isolation signal deinterleaved by the first deinterleaving unit and the noise variance deinterleaved by the second deinterleaving unit; and
an error correcting code decoding unit configured to decode an error correcting code using the likelihood ratio.

**11.** A transmission method for generating an OFDM signal to be transmitted from a plurality of transmit antennas, comprising the steps of:

mapping a transmission signal onto an IQ plane to generate a carrier-modulated carrier symbol;
interleaving the carrier symbol in a frequency domain and between transmit antennas to generate interleaved data for each transmit antenna; and
constructing an OFDM frame for the interleaved data for each transmit antenna and generating an OFDM signal to be transmitted from the transmit antennas.

**12.** A transmission method for generating an OFDM signal to be transmitted from a plurality of transmit antennas per channel, comprising the steps of:

mapping transmission signals for the plurality of channels onto an IQ plane to generate carrier-modulated carrier symbols for the plurality of channels;
interleaving the carrier symbols for the plurality of channels in a frequency domain and between transmit antennas to generate interleaved data for each transmit antenna; and
constructing an OFDM frame for the interleaved data for each transmit antenna and generating an OFDM signal to be transmitted from the transmit antennas.

**13.** A reception method for processing an OFDM signal received from a plurality of receive antennas, comprising the steps of:

generating an isolation signal by using a channel response to perform waveform equalization and isolation on an OFDM signal;
performing first deinterleaving by deinterleaving the isolation signal in a frequency domain and between receive antennas;
calculating a noise variance of the OFDM signal;
performing second deinterleaving by deinterleaving the noise variance in the frequency domain and between receive antennas;
calculating a likelihood ratio using the isolation signal deinterleaved in the first deinterleaving step and the noise variance deinterleaved in the second deinterleaving step; and
decoding an error correcting code using the likelihood ratio.

# FIG. 1

# FIG. 2

# FIG. 3

True symbol point

True noise variance

Data symbol

Q

Measured data
symbol point P

Noise variance when
incorrectly recognized as
nearby symbol

I

AC, TMCC symbol

AC, TMCC symbol

*FIG. 4*

EP 2 782 278 A1

# FIG. 5

(a)：Before interleaving

←———————————— 1 OFDM carrier symbol ——————————————→

←———— Data segment No.0 ————→ ←———— Data segment No.1 ————→   ←———— Data segment No.n-1 ————→

| 0 | 1 | ··· | 383 | 384 | 385 | ··· | 767 | ··· | 384(n-1) | 384(n-1)+1 | ··· | 384n-1 |

(b)：After interleaving

←———————————— 1 OFDM carrier symbol ——————————————→

←———— Data segment No.0 ————→ ←———— Data segment No.1 ————→   ←———— Data segment No.n-1 ————→

| 0 | n | ··· | 383n | 1 | n+1 | ··· | 383n+1 | ··· | n-1 | 2n-1 | ··· | 384n-1 |

EP 2 782 278 A1

# FIG. 6

(a): Before interleaving

| 0 | 1 | 2 | ・・・ | 383 |
|---|---|---|---|---|

(b): After interleaving

| k mod 384 | k+1 mod 384 | k+2 mod 384 | ・・・ | k+383 mod 384 |
|---|---|---|---|---|

k : Segment number

# FIG. 7

(a): Before interleaving

| 0 | 1 | 2 | 3 | 4 | ・・・ | 383 |
|---|---|---|---|---|------|-----|

(b): After interleaving

| 246 | 190 | 314 | 75 | 383 | ・・・ | 275 |
|-----|-----|-----|----|-----|------|-----|

## FIG. 8

EP 2 782 278 A1

FIG. 9

# FIG. 10

(a)：Before interleaving

|←————————————————— 1 OFDM carrier symbol ——————————————————→|

|←—— Data segment No.0 ——→|←—— Data segment No.1 ——→| |←—— Data segment No.n−1 ——→|

| 0 | 1 | 2 | 3 | ··· | 766 | 767 | 768 | 769 | 770 | 771 | ··· | 1534 | 1535 | ··· | 768·(n−1) | 768·(n−1)+1 | 768·(n−1)+2 | 768·(n−1)+3 | ··· | 768n−2 | 768n−1 |

(b)：After interleaving

|←————————————————— 1 OFDM carrier symbol ——————————————————→|

|←—— Data segment No.0 ——→|←—— Data segment No.1 ——→| |←—— Data segment No.n−1 ——→|

| 0 | n | 2n | 3n | ··· | 766n | 767n | 1 | n+1 | 2n+1 | 3n+1 | ··· | 766n+1 | 767n+1 | ··· | n−1 | 2n−1 | 3n−1 | 4n−1 | ··· | 767n−1 | 768n−1 |

EP 2 782 278 A1

## FIG. 11

Frequency/polarized wave interleaving unit

15

153-1
First polarized wave data rotation unit

154-1
First polarized wave data randomization unit

First polarized wave intra-segment interleaving unit

155
Inter-segment interleaving unit

156
Data distribution unit

Second polarized wave intra-segment interleaving unit

Second polarized wave data rotation unit

Second polarized wave data randomization unit

153-2

154-2

EP 2 782 278 A1

# *FIG. 12*

(a)：Before interleaving

$\longleftarrow$ 2 OFDM carrier symbols $\longrightarrow$

| $\longleftarrow$ Data segment No.0 $\longrightarrow$ | | | | $\longleftarrow$ Data segment No.1 $\longrightarrow$ | | | | | $\cdots$ | $\longleftarrow$ Data segment No.2n-1 $\longrightarrow$ | | | |

| 0 | 1 | $\cdots$ | 383 | 384 | 385 | $\cdots$ | 767 | $\cdots$ | $384(2n-1)$ | $384(2n-1)+1$ | $\cdots$ | $384 \cdot 2n-1$ |

(b)：After interleaving

$\longleftarrow$ 2 OFDM carrier symbols $\longrightarrow$

| $\longleftarrow$ Data segment No.0 $\longrightarrow$ | | | | $\longleftarrow$ Data segment No.1 $\longrightarrow$ | | | | | $\cdots$ | $\longleftarrow$ Data segment No.2n-1 $\longrightarrow$ | | | |

| 0 | 2n | $\cdots$ | $383 \cdot 2n$ | 1 | 2n+1 | $\cdots$ | $383 \cdot 2n+1$ | $\cdots$ | 2n-1 | $2 \cdot 2n-1$ | $\cdots$ | $384 \cdot 2n-1$ |

EP 2 782 278 A1

# FIG. 13

(a) : Before interleaving

(b) : After interleaving

# FIG. 14

15

```
┌─────────────────────────────────────────────────────┐
│ Frequency/polarized wave interleaving unit           │
│                                                       │
│              157                                      │
│        ┌──────────────┐                               │
│        │ Random number │                              │
│        │ table storage │                              │
│        │    unit       │                              │
│        └──────────────┘                               │
│               ↕                          159          │
│        ┌──────────────┐        ┌──────────────┐       │
│   ──→  │    Data      │   ──→  │    Data      │  ──→  │
│        │ randomization│        │ distribution │  ──→  │
│        │    unit      │        │    unit      │       │
│        └──────────────┘        └──────────────┘       │
│               158                                     │
└─────────────────────────────────────────────────────┘
```

# FIG. 15

EP 2 782 278 A1

*FIG. 16*

3 — Transmission device

Transmission signal →

11 Error correcting code unit →
12 Bit interleaving unit →
13 Mapping unit →
14 Time interleaving unit →
18 Frequency/polarized wave/channel interleaving unit

160-1 First channel output processing unit

16-1 First polarized wave output processing unit
- 161-1 First polarized wave OFDM frame construction unit
- 162-1 First polarized wave IFFT unit
- 163-1 First polarized wave GI adding unit
→ 17-1

16-2 Second polarized wave output processing unit
- 161-2 Second polarized wave OFDM frame construction unit
- 162-2 Second polarized wave IFFT unit
- 163-2 Second polarized wave GI adding unit
→ 17-2

160-2 Second channel output processing unit

16-3 First polarized wave output processing unit
- 161-3 First polarized wave OFDM frame construction unit
- 162-3 First polarized wave IFFT unit
- 163-3 First polarized wave GI adding unit
→ 17-3

16-4 Second polarized wave output processing unit
- 161-4 Second polarized wave OFDM frame construction unit
- 162-4 Second polarized wave IFFT unit
- 163-4 Second polarized wave GI adding unit
→ 17-4

# FIG. 17

EP 2 782 278 A1

# FIG. 18

**18** — Frequency/polarized wave/channel interleaving unit

**180-1** — First channel frequency interleaving unit

First polarized wave frequency interleaving unit

**182-1** First polarized wave inter-segment interleaving unit → **183-1** First polarized wave data rotation unit → **184-1** First polarized wave data randomization unit

Second polarized wave frequency interleaving unit

Second polarized wave inter-segment interleaving unit **182-2** → Second polarized wave data rotation unit **183-2** → Second polarized wave data randomization unit **184-2**

**181** Data distribution unit

**180-2** — Second channel frequency interleaving unit

First polarized wave frequency interleaving unit

**182-3** First polarized wave inter-segment interleaving unit → **183-3** First polarized wave data rotation unit → **184-3** First polarized wave data randomization unit

Second polarized wave frequency interleaving unit

Second polarized wave inter-segment interleaving unit **182-4** → Second polarized wave data rotation unit **183-4** → Second polarized wave data randomization unit **184-4**

## FIG. 19

18 — Frequency/polarized wave/channel interleaving unit

First channel intra-segment interleaving unit

190-1

183-1 First polarized wave data rotation unit → 184-1 First polarized wave data randomization unit

First polarized wave intra-segment interleaving unit

Second polarized wave intra-segment interleaving unit

Second polarized wave data rotation unit → Second polarized wave data randomization unit

183-2 / 184-2

185 Inter-segment interleaving unit → 186 Data distribution unit

190-2

Second channel intra-segment interleaving unit

183-3 First polarized wave data rotation unit → 184-3 First polarized wave data randomization unit

First polarized wave intra-segment interleaving unit

Second polarized wave intra-segment interleaving unit

Second polarized wave data rotation unit → Second polarized wave data randomization unit

183-4 / 184-4

EP 2 782 278 A1

# FIG. 20

EP 2 782 278 A1

(a)： Before interleaving

|←————————————————————— 4 OFDM carrier symbols —————————————————————→|

|←——————— Data segment No.0 ———————→|←——————— Data segment No.1 ———————→| |←——————— Data segment No.4n-1 ———————→|

| 0 | 1 | $\cdots$ | 383 | 384 | 385 | $\cdots$ | 767 | $\cdots$ | 384(4n-1) | 384(4n-1)+1 | $\cdots$ | 384·4n-1 |

(b)： After interleaving

|←————————————————————— 4 OFDM carrier symbols —————————————————————→|

|←——————— Data segment No.0 ———————→|←——————— Data segment No.1 ———————→| |←——————— Data segment No.4n-1 ———————→|

| 0 | 4n | $\cdots$ | 383·4n | 1 | 4n+1 | $\cdots$ | 383·4n+1 | $\cdots$ | 4n-1 | 2·4n-1 | $\cdots$ | 384·4n-1 |

# FIG. 21

(a): Before interleaving

(b): After interleaving

EP 2 782 278 A1

# FIG. 22

18

Frequency/polarized wave/channel
interleaving unit

187

Random number
table storage
unit

Data
randomization
unit

188

Data
distribution
unit

189

# FIG. 23

# FIG. 24

Start

↓

Perform error correcting
coding on the transmission signal —— S101

↓

Perform bit interleaving —— S102

↓

Perform mapping —— S103

↓

Perform time interleaving —— S104

↓

Perform interleaving in frequency
domain and between polarized waves
(between transmit antennas) —— S105

↓

Construct OFDM frame,
transmit OFDM signal —— S106

↓

End

# FIG. 25

```
┌─────────────┐
(   Start   )
└─────────────┘
      │
      ▼
┌───────────────────────────┐
│    Receive OFDM signal     │ ~ S201
└───────────────────────────┘
      │
      ▼
┌───────────────────────────┐
│  Calculate the channel response │ ~ S202
└───────────────────────────┘
      │
      ▼
┌───────────────────────────┐
│  Perform waveform equalization and │ ~ S203
│ isolation to generate an isolation signal │
└───────────────────────────┘
      │
      ▼
┌───────────────────────────┐
│   Deinterleave the isolation signal │ ~ S204
│   in the frequency domain and between │
│ polarized waves (between receive antennas) │
└───────────────────────────┘
      │
      ▼
┌───────────────────────────┐
│  Calculate the noise variance │ ~ S205
└───────────────────────────┘
      │
      ▼
┌───────────────────────────┐
│  Deinterleave the noise variance │ ~ S206
│  in the frequency domain and between │
│ polarized waves (between receive antennas) │
└───────────────────────────┘
      │
      ▼
┌───────────────────────────┐
│  Calculate the likelihood ratio │ ~ S207
└───────────────────────────┘
      │
      ▼
┌───────────────────────────┐
│  Time deinterleave │ ~ S208
│  the likelihood ratio │
└───────────────────────────┘
      │
      ▼
┌───────────────────────────┐
│ Bit deinterleave the likelihood ratio │ ~ S209
└───────────────────────────┘
      │
      ▼
┌───────────────────────────┐
│ Decode the error correcting code │ ~ S210
└───────────────────────────┘
      │
      ▼
┌─────────────┐
(    End    )
└─────────────┘
```

**INTERNATIONAL SEARCH REPORT**

| | International application No. |
|---|---|
| | PCT/JP2012/007374 |

**A. CLASSIFICATION OF SUBJECT MATTER**
*H04J99/00*(2009.01)i, *H03M13/27*(2006.01)i, *H04B7/04*(2006.01)i, *H04J11/00* (2006.01)i

According to International Patent Classification (IPC) or to both national classification and IPC

**B. FIELDS SEARCHED**

Minimum documentation searched (classification system followed by classification symbols)
H04J99/00, H03M13/27, H04B7/04, H04J11/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
IEEE Xplore, CiNii

**C. DOCUMENTS CONSIDERED TO BE RELEVANT**

| Category* | Citation of document, with indication, where appropriate, of the relevant passages | Relevant to claim No. |
|---|---|---|
| Y | SeokJoon Hong et al., Interleaved Spatial Diversity Transmission with Coordinate Interleaver for MIMO-OFDM Systems, Vehicular Technology Conference, 2009. VTC Spring 2009., 2009.04.29, pp.1-4 | 1-13 |
| Y | WO 2011/086953 A1 (Sony Corp.), 21 July 2011 (21.07.2011), fig. 6, 7C & JP 2011-146832 A & CN 102714862 A | 1-13 |
| Y | JP 4594361 B2 (Samsung Electronics Co., Ltd.), 08 December 2010 (08.12.2010), fig. 1, 5 & JP 2008-61253 A & US 2008/0056414 A1 & EP 1895680 A2 & KR 10-2008-0021494 A & KR 10-2008-0020585 A & CN 101227255 A | 8,9,12 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 10 December, 2012 (10.12.12) | 18 December, 2012 (18.12.12) |

| Name and mailing address of the ISA/ Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2012/007374

C (Continuation).    DOCUMENTS CONSIDERED TO BE RELEVANT

| Category* | Citation of document, with indication, where appropriate, of the relevant passages | Relevant to claim No. |
|---|---|---|
| Y | Takuya SHITOMI et al., "Technology for the next generation of digital terrestrial broadcasting: field experiment of dual polarized MIMO transmission using circularly and skew polarization", ITE Technical Report, 04 March 2011 (04.03.2011), vol.35, no.13, pages 1 to 4, BCT2011-41 | 9 |
| Y | JP 2011-129981 A  (International Business Machines Corp.), 30 June 2011 (30.06.2011), claims 1 to 5; paragraphs [0002] to [0034] & US 2011/0145675 A1 | 10,13 |
| P,X | Shingo ASAKURA et al., "Technology for the next generation of digital terrestrial broadcasting : A study of decoding method of LDPC code in dual polarized MIMO transmission", ITE Technical Report, 08 June 2012 (08.06.2012), vol.36, no.23, pages 25 to 30, BCT2012-58 | 1-13 |
| P,X P,A | Shingo ASAKURA et al., "Technology for the next generation of digital terrestrial broadcasting : A study of multi dimensional interleaving", ITE Technical Report, 2012.02, vol.36, no.6, pages 53 to 58, BCT2012-25 | 1-9,11,12 10,13 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011253146 A
- JP 2012183571 A

- JP 2008505558 A

**Non-patent literature cited in the description**

- **NAKAHARA.** A Study on soft decision decoding of 64QAM modulated OFDM signals under multi path distortion. *ITE Technical Report,* June 1998, vol. 22 (34), 1-6